# EUROPÄISCHE PATENTSCHRIFT

(11) **EP 2 773 483 B1**
(45) Veröffentlichungstag und Bekanntmachung des Hinweises auf die Patenterteilung: **19.08.2015**
(21) Anmeldenummer: 12784413.2
(22) Anmeldetag: 31.10.2012
(51) Int. Cl.: B23K 11/24, B23K 11/31, H01F 27/40

(54) **WIDERSTANDSSCHWEISSVORRICHTUNG MIT EINER AN EINER SCHWEISSZANGE ANGEORDNETEN STROMQUELLE**
RESISTANCE WELDING DEVICE COMPRISING A CURRENT SOURCE ARRANGED ON A WELDING GUN
DISPOSITIF DE SOUDAGE PAR RÉSISTANCE POURVU D'UNE SOURCE DE COURANT SITUÉE SUR UNE PINCE À SOUDER

(30) Priorität: 31.10.2011 AT 15992011
(43) Veröffentlichungstag der Anmeldung: 10.09.2014
(73) Patentinhaber: Fronius International GmbH, 4643 Pettenbach (AT)
(72) Erfinder: ARTELSMAIR, Bernhard, A-4643 Pettenbach (AT); SCHULTSCHIK, Christoph, A-4643 Pettenbach (AT); NEUBÖCK, Johannes, A-4652 Steinerkirchen/Tr. (AT); WOLFSGRUBER, Stefan, A-4810 Gmunden (AT)
(74) Vertreter: Sonn & Partner Patentanwälte
(86) Internationale Anmeldenummer: PCT/AT2012/000275
(87) Internationale Veröffentlichungsnummer: WO 2013/063628

(56) Entgegenhaltungen:
- DE-B3-102007 042 771
- DE-U1-202009 012 249
- JP-A- 2003 318 045
- KR-A- 20090 029 971

## Beschreibung

Die Erfindung betrifft eine Widerstandsschweißvorrichtung mit einer Stromquelle zur Bereitstellung eines Schweißstroms zum Verschweißen von Werkstücken, mit einer Schweißzange mit zwei Zangenarmen mit jeweils einer Elektrode zum Einprägen des Schweißstroms in die Werkstücke, wobei die Stromquelle einen Hochstromtransformator mit zumindest einer Primärwicklung und zumindest einer Sekundärwicklung mit Mittelanzapfung, einen mit der zumindest einen Sekundärwicklung des Hochstromtransformators verbundenen Synchrongleichrichter mit Schaltelementen und eine Schaltung zur Ansteuerung der Schaltelemente des Synchrongleichrichters aufweist, siehe z.B. DE 10 2007 042 771 B.

Die vorliegende Erfindung bezieht sich auf Widerstandsschweißvorrichtungen, insbesondere Punktschweißvorrichtungen, bei welchen besonders hohe Gleichströme in der Größenordnung von einigen kA auftreten. Auch andere Geräte, bei welchen derart hohe Gleichströme eingesetzt werden, sind vom Gegenstand der vorliegenden Patentanmeldung umfasst. Beispiele für derartige Geräte sind Batterieladegeräte, Teilchenbeschleuniger, Einrichtungen zur Galvanisierung oder dgl. Die WO 2007/041729 A1 beschreibt beispielsweise ein Batterieladegerät und einen Stromwandler zur Herstellung eines entsprechend hohen Gleichstroms.

Bei Widerstandsschweißvorrichtungen werden die erforderlichen hohen Gleichströme mit Hilfe entsprechender Hochstromtransformatoren und Gleichrichter bereitgestellt. Aufgrund der hohen auftretenden Ströme sind Dioden-Gleichrichter wegen der relativ hohen Verluste nachteilig, weshalb hauptsächlich aktive Gleichrichter mit Schaltelementen, die durch entsprechende Transistoren gebildet sind, eingesetzt werden. Aber auch Widerstandsschweißvorrichtungen mit aktiven Gleichrichtern, beispielsweise Synchrongleichrichtern, weisen relativ hohe Verluste und somit relativ geringe Wirkungsgrade auf. Da beim Stand der Technik durch den üblichen getrennten Aufbau, beispielsweise von Hochstromtransformator und Gleichrichtung, erhebliche Leitungslängen und somit Leitungsverluste anfallen, wird ein sehr schlechter Wirkungsgrad aufgrund der hohen Ströme verursacht.

Beispielsweise beschreibt die DE 10 2007 042 771 B3 ein Verfahren zum Betrieb der Stromversorgung einer Widerstandsschweißvorrichtung unter Verwendung eines Synchrongleichrichters, durch welches die Verlustleistung reduziert und der Wirkungsgrad verbessert werden kann.

Die DE 20 2009 012 249 U1 zeigt eine Widerstandsschweißvorrichtung bei dem der Schweißtransformator zwischen den Zangenarmen der Widerstandsschweißvorrichtung angeordnet ist, wodurch eine verkleinerte und kompaktere Bauform und ein reduzierter Montageaufwand erreicht wird.

Die JP 2003/318045 A beschreibt einen Transformator bei dem die Windungen schichtförmig aufgebaut sind, der jedoch für die Verwendung in einer Widerstandsschweißvorrichtung mit den zu erwartenden hohen Schweißströmen absolut ungeeignet wäre.

Schließlich zeigt die KR 2009/0029971 A eine Stromquelle mit vier Kontakten ohne jedoch einen Hinweis über die Montage der Stromquelle zu geben.

Bei Fertigungsstraßen in der Autoindustrie wird eine Vielzahl an Punktschweißvorrichtungen (häufig einige 100 bis 1000 Einzelgeräte) zur Herstellung verschiedener Verbindungen an der Karosserie und am Fahrgestell des herzustellenden Fahrzeugs eingesetzt. Nachdem bereits die einzelnen Punktschweißvorrichtungen sehr hohe Verluste durch die Hochstromtransformatoren und Leitungen und Schaltelemente verursachen, bewegen sich die gesamten auftretenden Verluste bei derartigen Fertigungsstraßen in enorm hohen Dimensionen, beispielsweise zwischen 1MW und 50MW. Da sich die Verluste hauptsächlich in Form von Verlustwärme niederschlagen, sind wiederum Maßnahmen zu ergreifen, die Wärme abzuführen, wodurch die gesamte Energiebilanz noch weiter verschlechtert wird.

Ein weiterer Nachteil ergibt sich dadurch, dass durch die hohen Verluste für derartige Anlagen sehr hohe Anschlussleistungen des Versorgungsnetzes benötigt werden, wodurch sehr hohe Kosten für die Herstellung, Inbetriebnahme und den Betrieb einer derartigen Anlage entstehen.

Zur Herstellung eines einzigen Schweißpunkts mit einem Schweißstrom von 20kA wird nach dem Stand der Technik aus heutiger Sicht beispielsweise eine Anschlussleistung des Versorgungsnetzes von bis zu 150kW benötigt, wobei beim genannten Schweißstrom Verluste von bis zu 135kW resultieren, wodurch ein sehr schlechter Wirkungsgrad von nur etwa 10% erreicht wird.

Die Aufgabe der vorliegenden Erfindung besteht daher in der Schaffung einer Widerstandsschweißvorrichtung durch welche die Verluste reduziert werden können und die Energiebilanz und der Wirkungsgrad verbessert werden kann. Nachteile bekannter Vorrichtungen sollen reduziert oder vermieden werden.

Gelöst wird die erfindungsgemäße Aufgabe durch eine obengenannte Widerstandsschweißvorrichtung, bei der die Stromquelle zur Bereitstellung des Schweißstroms zum Verschweißen der Werkstücke an der Schweißzange angeordnet ist, und die Stromquelle zur Bildung einer Mehrpunktkontaktierung, insbesondere Vierpunktkontaktierung, am Ausgang des Synchrongleichrichters zumindest vier Kontakte aufweist, wobei der Schweißstrom zumindest halbiert und dadurch die Übergangsverluste reduziert werden, wobei zwei erste Kontakte einer Polarität mit dem einen Zangenarm und zwei weitere Kontakte einer entgegengesetzten Polarität mit dem anderen Zangenarm verbunden sind, und wobei an zumindest zwei Kontakten leitungslos der Zangenarm befestigt ist. Durch eine derartige Mehrpunktkontaktierung können Leitungen, die üblicherweise zum Verbinden der Sekundärseite des Hochstromtransformators bzw. des Ausgangs des Synchrongleichrichters mit den Zangenarmen bzw. den Elektroden der Widerstandsschweißvorrichtung erforderlich sind, eingespart oder deren Länge verringert werden und somit die Ohm'schen Verluste wie auch die Kontaktübergangsverluste reduziert werden. Somit können möglichst kurze Leitungen mit möglichst großen Querschnitten eingesetzt werden, wobei gleichzeitig die Flexibilität der Schweißzange erhalten bleibt. Ein weiterer Vorteil liegt darin, dass aufgrund einer derartigen Kontaktierung die Verluste, insbesondere Kontaktübergangswiderstandsverluste, reduziert werden. Aufgrund der mindestens vier Kontakte (zwei Kontakte je Polarität, also zwei Kontakte für den Pluspol und zwei Kontakte für den Minuspol) wird gemäß der Erfindung der zu übertragende Gleichstrom halbiert, wodurch auch eine Reduktion der Übergangsverluste bewirkt wird. Damit wird auch erreicht, dass die aktiven Kontaktflächen wesentlich vergrößert werden können und somit wiederum die Übergangswiderstände reduziert werden. Durch die erfindungsgemäße Widerstandsschweißvorrichtung wird erreicht, dass bei einem Schweißstrom von beispielsweise 20kA die Anschlussleistung nunmehr lediglich 75kW (gegenüber 150kW bei vergleichbaren Vorrichtungen des Standes der Technik) betragen muss, wobei Verluste von 60kW auftreten. Somit kann gegenüber dem Stand der Technik etwa eine Verdopplung des Wirkungsgrads auf etwa 20% und mehr erzielt werden. Besondere Vorteile ergeben sich dadurch, dass an zumindest zwei Kontakten leitungslos und somit ohne Kontaktübergangswiderständen der Zangenarm befestigt ist. Dies kann dadurch erzielt werden dass diese beiden Kontakte quasi in der Stromquelle integriert sind, welche mit den entsprechenden Teilen der Widerstandsschweißvorrichtung, insbesondere den Zangenarmen, direkt, also ohne Verlegung von Leitungen, verbunden werden. Durch das direkte Verbinden eines Zangenarmes mit den Kontakten des Hochstromtransformators wird somit eine leitungslose Verbindung erreicht, wogegen der zweite Zangenarm mit sehr kurzen Leitungen mit den weiteren Kontakten verbunden werden muss. Auf diese Weise können die Leitungsverluste sehr stark reduziert werden, da die Leitungslängen auf das Minimum reduziert werden können. Beim Stand der Technik wird im optimalen Fall der Hochstromtransformator möglichst nahe an die Schweißzange positioniert und anschließend vom Hochstromtransformator zur Schweißzange die Leitungen verlegt, wogegen bei der erfindungsgemäßen Lösung der Hochstromtransformatör in der Schweißzange integriert ist und gleichzeitig ein Zangenarm direkt am Hochstromtransformator befestigt ist, sodass nur noch der zweite Zangenarm mit einer Leitung oder mit zwei kurzen Leitungen angeschlossen werden muss. Selbstverständlich können anstelle von Leitungen beispielsweise auch Schleifkontakte oder andere Verbindungselemente verwendet werden.

Gemäß einem weiteren Merkmal der Erfindung ist vorgesehen, dass die zwei ersten Kontakte der einen Polarität und die zwei weiteren Kontakte der entgegengesetzten Polarität jeweils gegenüberliegend angeordnet sind, wobei die zwei weiteren Kontakte gegenüber den zwei ersten Kontakten im Wesentlichen um 90° zueinander versetzt angeordnet sind. Durch eine derartige geometrische Anordnung der Kontakte an der Stromquelle können Leitungen gänzlich vermieden oder deren Längen reduziert werden und somit Ohm'sche Verluste wie auch Kontaktverluste deutlich verringert werden. Damit können auch möglichst große Kontaktflächen geschaffen werden. Beispielsweise weist jeder der vier Kontakte bei der Dimensionierung eines Hochstromtransformators bzw. einer Stromquelle für die Bereitstellung eines Gleichstroms von 20kA eine Fläche zwischen 15cm x 15cm bis 25cm x 25cm, bevorzugt 20cm x 20cm, auf.

Weitere Verringerungen der Verluste können dadurch erzielt werden, dass der Synchrongleichrichter und die Ansteuerschaltung der Stromquelle im Hochstromtransformator integriert sind, sowie dass der Synchrongleichrichter mehrere parallel geschaltete Schaltelemente aufweist und die Schaltelemente des Synchrongleichrichters leitungslos mit der zumindest einen Sekundärwicklung des Hochstromtransformators verbunden sind. Durch diese Konstruktion sind keine Leitungen zwischen dem Synchrongleichrichter und der Sekundärseite des Hochstromtransformators erforderlich, wodurch auch allfällige Ohm'sche Verluste und weitere Verluste durch derartige Leitungen wegfallen. Auch allfällige Versorgungsschaltungen für den Synchrongleichrichter und die Ansteuerschaltung sind vorzugsweise im Hochstromtransformator integriert. Bevorzugt wird für die Versorgung des Hochstromtransformators das Leistungsteil möglichst nahe an diesem positioniert, um möglichst kurze Anschlussleitungen und somit möglichst geringe Leitungsverluste und Leitungsinduktivitäten zu erreichen.

Vorteilhafterweise sind die Schaltelemente des Synchrongleichrichters durch Feldeffekttransistoren gebildet, deren Drain-Anschlüsse durch deren Gehäuse gebildet sind, welche Gehäuse leitungslos mit der zumindest einen Sekundärwicklung des Hochstromtransformators verbunden sind. Diese Anordnung sieht daher vor, dass die Sekundärwicklungen des Hochstromtransformators direkt mit den Gehäusen der Feldeffekttransistoren des Synchrongleichrichters kontaktiert werden, wodurch keine Leitungen zwischen diesen Einheiten erforderlich sind.

Zur Erzielung des erforderlichen Übersetzungsverhältnisses des Hochstromtransformators zur Erzeugung des hohen sekundärseitigen Stroms weist dieser gemäß einem weiteren Merkmal der Erfindung mehrere, vorzugsweise zumindest 10, in Serie geschaltete Primärwicklungen und mehrere, vorzugsweise zumindest 10, parallel geschaltete Sekundärwicklungen mit Mittelanzapfung auf. Der Primärstrom durchfließt die in Serie geschalteten Primärwicklungen des Hochstromtransformators, wohingegen der relativ hohe sekundärseitige Strom auf die mehreren, vorzugsweise zumindest 10, parallel geschalteten Sekundärwicklungen aufgeteilt wird. Die sekundärseitigen Teilströme werden den entsprechenden Schaltelementen des Synchrongleichrichters zugeführt. Durch eine derartige Aufteilung ergibt sich trotz geringer primär- und sekundärseitiger Windungszahlen ein entsprechend hohes Übersetzungsverhältnis. Durch diese Konstruktion sind im Gegensatz zu herkömmlichen Hochstromtransformatoren primärseitig geringere Windungszahlen erforderlich, wodurch die Länge der Primärwicklung verringert werden kann und dadurch die Ohm'schen Verluste reduziert werden können. Durch die reduzierte primäre Windungszahl und somit eine daraus resultierende Reduktion der Leitungslänge ist wiederum die systemtypische Streuinduktivität des Hochstromtrafos verringert, wodurch der Hochstromtransformator mit höheren Schaltfrequenzen, beispielsweise 10kHz, betrieben werden kann. Die höheren Schaltfrequenzen bewirken wiederum eine Verringerung der Baugröße und des Gewichts des Hochstromtransformators und somit vorteilhafte Einbaumöglichkeiten. Damit kann der Hochstromtransformator so nahe wie möglich an die Elektroden der Widerstandsschweißvorrichtung positioniert werden. Somit kann auch die Traglast des Roboters aufgrund des geringen Gewichts des Hochstromtransformators verringert werden, sodass mit einem kleinen billigeren Roboter das Auslangen gefunden werden kann.

Das Übersetzungsverhältnis des Hochstromtransformators beträgt 10 bis 1000, vorzugsweise zumindest 100, um die Erzeugung des hohen sekundärseitigen Stroms zu gewährleisten.

Eine besonders vorteilhafte Konstruktion der Widerstandsschweißvorrichtung kann dadurch erreicht werden, dass der Hochstromtransformator einen I-förmigen Träger aus elektrisch leitfähigem Material aufweist, in dessen Ausnehmungen jeweils zumindest ein Ringkern angeordnet ist, wobei jeweils ein Anschluss jeder Sekundärwicklung direkt mit einer Innenfläche des I-Trägers kontaktiert ist, und die Außenflächen des I-Trägers die zwei ersten Kontakte der Stromquelle bilden. Der I-Träger bildet also die Basis des Hochstromtransformators, um welche die Sekundärwicklungen derartig angeordnet sind, dass keine Verbindungsleitungen erforderlich sind. Die Außenflächen des I-Trägers stellen die zwei ersten Kontakte der Stromquelle dar, welche direkt, also leitungslos, mit einem Zangenarm der Widerstandsschweißvorrichtung verbunden werden. Eine Platz sparende Anordnung wird dadurch erreicht, dass die Ringkerne nicht kreisförmig, sondern oval ausgeführt sind. Bevorzugt werden geschlossene Ringkerne eingesetzt. Durch diese Ausbildung wird die Serien-/Parallelschaltung der Primärwicklungen und Sekundärwicklungen erzielt, durch welche das Übersetzungsverhältnis des Hochstromtransformators für den hohen bereitzustellenden Gleichstrom bei gleichzeitig niedrigen Windungszahlen der Primärwicklungen und Sekundärwicklungen erreicht werden kann. Ein derartiger Aufbau zahlt sich insbesondere dann aus, wenn auf jeder Seite des I-Trägers zumindest drei parallel geschaltete Sekundärwicklungen angeordnet werden.

Vorteilhafterweise ist die Mittelanzapfung der zumindest einen Sekundärwicklung des Hochstromtransformators leitungslos mit dem I-Träger verbunden. Damit können entsprechende Leitungen zwischen den einzelnen Komponenten entfallen. Durch die direkte Anbindung der Sekundärwicklung an den Mittelpunkt des I-Trägers wird auch eine wesentliche Vergrößerung der Anschlussfläche erzielt und können somit wieder Übergangsverluste und Leitungsverluste reduziert werden.

Bei der oben genannten Konstruktion des Hochstromtransformators mit I-Träger ist die zumindest eine Primärwicklung des Hochstromtransformators durch den zumindest einen Ringkern, insbesondere die symmetrisch beiderseits in den Ausnehmungen des I-Trägers angeordneten Ringkernen, verlaufend angeordnet. Durch eine derartige Anordnung der Primärwicklung kann eine optimale magnetische Kopplung zu den Sekundärwicklungen erreicht werden.

Wie bereits oben erwähnt, werden die Sekundärwicklungen über den I-Träger des Hochstromtransformators elektrisch miteinander verbunden. Die jeweiligen anderen Anschlüsse jeder Sekundärwicklung sind über den Synchrongleichrichter und die Ansteuerschaltung vorzugsweise direkt mit jeweils einer Kontaktplatte aus elektrisch leitfähigem Material verbunden, welche Kontaktplatten über den Ausnehmungen des I-Trägers und die darin angeordeten Sekundärwicklungen angeordnet sind, wobei die Außenflächen dieser Kontaktplatten die zwei weiteren Kontakte der Stromquelle bilden.

Die Anschlüsse der zumindest einen Primärwicklung des Hochstromtransformators sind gemäß einem weiteren Merkmal der Erfindung über zumindest eine Öffnung an eine Außenfläche des I-Trägers herausgeführt. Von dort können die Anschlüsse der Primärwicklung des Hochstromtransformators mit der entsprechenden Spannungsquelle bzw. dem Leistungsteil verbunden werden.

Eine vorteilhafte Ausführungsform der Widerstandsschweißvorrichtung ergibt sich dadurch, dass jeweils eine Sekundärwicklung mit Mittelanzapfung des Hochstromtransformators durch zwei voneinander isolierte Bleche aus elektrisch leitfähigem Material mit im Wesentlichen S-förmigem, gegengleichen Verlauf um den Querschnitt eines Ringkerns und durch den Ringkern gebildet ist, wobei die außenliegenden Flächen der Bleche die Kontakte für die Verbindung mit den Schaltelementen des Synchrongleichrichters bzw. den Elektroden bilden. Damit wird ein äußerst Platz sparender und kompakter Aufbau erzielt. Gleichzeitig stehen für die Verbindung der Sekundärwicklung mit dem Mittelpunkt bzw. Mittelsteg des I-Trägers und den Schaltelementen des Synchrongleichrichters sehr große Kontaktflächen zur Verfügung, um mit möglichst wenig Verlusten den hohen Stromfluss zu gewährleisten.

Die Bleche zur Bildung der Sekundärwicklung des Hochstromtransformators sind durch eine Isolierschicht, beispielsweise eine Papierschicht, voneinander isoliert. Dadurch können zwei Sekundärwicklungen auf einem Ringkern angeordnet werden und somit die Baugröße, das Gewicht und die Verluste wesentlich verringert werden. Durch diese Anordnung wird sekundärseitig ein Mittelpunktgleichrichter realisiert, wobei der I-Träger mit dem verbundenen, insbesondere verlöteten einen Ende der Sekundärwicklungen den Mittelpunkt bilden.

Der I-Träger und die Kontaktplatten des Hochstromtransformators bilden vorzugsweise eine Würfel- oder Quaderförmige Einheit, wobei zwischen dem I-Träger und den Kontaktplatten eine elektrische Isolierung angeordnet ist. Die zwei Außenflächen des I-Trägers bilden die zwei ersten Kontakte und die zwei Außenflächen der Kontaktplatten die dazu um 90° winkelversetzten, zwei weiteren Kontakte der Stromquelle. Wenn sämtliche weitere Komponenten der Stromquelle zur Bereitstellung des Schweißstroms, wie der Synchrongleichrichter, die Ansteuerschaltung, die Versorgungsschaltungen für den Synchrongleichrichter und die Ansteuerschaltung in dieser Würfel- oder Quaderförmigen Einheit integriert sind, wird eine autarke Einheit gebildet, welche eingangsseitig lediglich mit dem Leistungsteil und ausgangsseitig mit den Zangenarmen bzw. Elektroden der Widerstandsschweißvorrichtung verbunden werden muss. Übliche Leitungen zwischen den einzelnen Schaltungen der Stromquelle können entfallen oder zumindest deutlich in ihrer Länge reduziert werden.

Wenn an den Stirnseiten des I-Trägers Deckplatten angeordnet sind, kann eine stabile Einheit des Hochstromtransformators in Würfel- bzw. Quaderform gebildet werden.

Wenn die Deckplatten ebenfalls aus elektrisch leitfähigem Material gebildet und mit den Kontaktplatten verschraubbar sind, kann eine elektrische Verbindung der Kontaktplatten erzielt werden. Dadurch kann eine gesonderte elektrische Leitung, welche die beiden Kontaktplatten elektrisch miteinander verbindet, entfallen, um einen Spannungs- bzw. Potentialausgleich herzustellen und somit eine Unsymmetrie der beiden Kontaktplatten zu vermeiden. Über die Deckplatten wird somit die elektrische Verbindung der beiden Kontaktplatten der symmetrischen Anordnung des Hochstromtransformators bzw. der Stromquelle zur Bereitstellung des Schweißstroms für die Widerstandsschweißvorrichtung hergestellt.

Der I-Träger und/oder die Kontaktplatten und/oder die Deckplatten und/oder die Bleche zur Bildung der Sekundärwicklung des Hochstromtransformators ist vorzugsweise aus Kupfer oder einer Kupferlegierung, vorzugsweise mit einer Silberbeschichtung, gebildet. Kupfer oder Kupferlegierungen weisen optimale elektrische Eigenschaften auf und zeigen gute Wärmeleitfähigkeit wodurch auftretende Wärmeverluste rascher abgeführt werden können. Die Silberbeschichtung verhindert eine Oxidation des Kupfers bzw. der Kupferlegierung. Anstelle von Kupfer oder Kupferlegierungen kommen auch Aluminium oder Aluminiumlegierungen in Frage, welche gegenüber Kupfer einen Gewichtsvorteil aufweisen, obgleich die Korrosionsbeständigkeit nicht so hoch ist. Anstelle einer Silberbeschichtung ist auch eine Beschichtung aus Zinn und anderen Materialien oder deren Verbindungen bzw. Schichten möglich.

Der I-Träger und/oder die Kontaktplatten können auch zumindest teilweise durch die Zangenarme der Widerstandsschweißvorrichtung gebildet sein. Auf diese Weise kann eine Konstruktion gebildet werden, bei der die Stromquelle zur Bereitstellung des Schweißstroms der Widerstandsschweißvorrichtung zumindest teilweise in dieser integriert ist.

An den Außenflächen des I-Trägers und den Außenflächen der Kontaktplatten können Verbindungseinrichtungen, vorzugsweise Bohrungen mit einem Gewinde zur Aufnahme von Schrauben, angeordnet sein. Über diese Verbindungseinrichtungen kann sowohl die mechanische als auch elektrische Verbindung der Stromquelle zu den Komponenten der Widerstandsschweißvorrichtung, insbesondere den Zangenarmen, oder anderen mit dem Gleichstrom zu versorgenden Geräten hergestellt werden. Darüber hinaus können über derartige Verbindungseinrichtungen verschiedene andere Elemente an den Außenflächen des I-Trägers bzw. der Kontaktplatten befestigt werden.

An den Anschlüssen einer Sekundärwicklung ist gemäß einem weiteren Merkmal der Erfindung jeweils ein Stromwandler zur Messung des Stroms durch diese Sekundärwicklung angeordnet, welche Stromwandler mit der Ansteuerschaltung verbunden sind. Über den Stromwandler erfolgt eine Messung des sekundärseitigen Stroms aufgrund dessen die Schaltelemente des Synchrongleichrichters betätigt werden, um die Durchlassverluste und die Schaltverluste zu minimieren. Bei symmetrischem Aufbau der Stromquelle mit einem I-Träger als Basis des Hochstromtransformators sind beiderseits des I-Trägers Sekundärwicklungen und auch beiderseits die Stromwandler angeordnet. Die Stromwandler sind jeweils direkt mit der daneben angeordneten Ansteuerschaltung kontaktiert und über entsprechende Leitungen mit der jeweiligen gegenüberliegenden Ansteuerschaltung verbunden. Wesentlich ist hierbei, dass aufgrund der Parallelschaltung der Sekundärwicklungen in jeder Wicklung immer der gleiche Strom fließt und somit der Stromfluss nur von einer Sekundärwicklung abgriffen werden muss, um auf den gesamten Stromfluss rückschliessen zu können. Bei einer Parallelschaltung von zehn Sekundärwicklungen wird daher nur ein Zehntel des gesamten sekundärseitigen Stromflusses von den Stromwandlern gemessen, weshalb diese wesentlich kleiner dimensioniert werden können. Damit wird wiederum eine Reduktion der Baugröße des Hochstromtransformators bzw. der Stromquelle erzielt.

Von Vorteil ist es, wenn die Stromwandler im Wesentlichen 90° zur Richtung des Schweißstroms orientiert angeordnet sind, da dadurch Störungen durch das durch den Schweißstrom hervorgerufene Magnetfeld und somit Messfehler reduziert werden können. Somit kann eine sehr genaue Messung durchgeführt werden.

Um Störungen durch Fremdmagnetfelder zu verhindern, ist jeder Stromwandler durch ein Gehäuse und bevorzugt eine Abschirmung aus magnetisch leitfähigem Material abgeschirmt. Dabei eignen sich Ferrite als Materialien für derartige Abschirmungen besonders.

Um die Durchlassverluste und Schaltverluste der Schaltelemente des Synchrongleichrichters zu minimieren, ist die Ansteuerschaltung zur Aktivierung der Schaltelemente des Synchrongleichrichters zu einem voreingestellten Zeitpunkt vor dem Erreichen des Nulldurchgangs des Stroms in der Sekundärwicklung ausgebildet. Durch diesen voreingestellten Zeitpunkt kann die Verzögerung, welche vom Erfassen des Nulldurchgangs des sekundärseitigen Stroms bis zur Aktivierung der jeweiligen Schaltelemente auftritt, ausgeglichen werden. Das heißt, es wird der Ein- und Ausschaltzeitpunkt der Schaltelemente des Synchrongleichrichters nicht mit dem Nulldurchgang des sekundärseitigen Stroms sondern mit Erreichen einer definierten Ein- und Ausschaltschwelle festgelegt. Die Ein- und Ausschaltschwelle wird entsprechend den zu erwartenden Schaltverzögerungen definiert. Allenfalls können die Ein- und Ausschaltschwellen verstellbar ausgebildet sein, um die Verluste noch mehr reduzieren zu können. Beispielsweise kann bei einem 20kA Hochstromtransformator der Schaltzeitpunkt 100ns vor dem Nulldurchgang festgelegt werden, sodass sämtlich Komponenten, insbesondere die Schaltelemente des Synchrongleichrichter, innerhalb dieser Zeitdauer geschaltet sein müssen.

Zur Abführung der entstehenden Verlustwärme in der Stromquelle der Widerstandsschweißvorrichtung sind im I-Träger und den Kontaktplatten vorzugsweise Kanäle zur Führung eines Kühlfluids angeordnet. Als Kühlfluid eignet sich insbesondere Wasser, es können aber auch gasförmige Kühlmittel durch die Kühlkanäle gefördert und darüber die Verlustwärme abgeführt werden.

Eine bevorzugte Ausführungsform der Kühlkanäle ist dadurch gegeben, dass an einer Außenfläche des I-Trägers zwei Einlässe zur Zuleitung des Kühlfluids und ein Auslass zur Ableitung des Kühlfluids angeordnet sind, wobei die Kühlkanäle von jedem Einlass zu den Kontaktplatten und über den I-Träger zum Auslass verlaufend angeordnet sind. Der Querschnitt des Auslasses entspricht der Summe der Querschnitte aller Einlässe. Durch diesen Verlauf der Kühlkanäle wird erreicht, dass zuerst die Kontaktplatten, an welchen die Platinen des Synchrongleichrichters und der Ansteuerschaltung mit den empfindlicheren Bauteilen angeordnet sind, mit dem entsprechend kalten Kühlfluid gekühlt werden. Danach werden die weniger empfindlichen Komponenten, insbesondere die Teile des Hochstromtransformators, nämlich der I-Träger, welcher mit den Sekundärwicklungen in Verbindung steht, gekühlt.

Die Ansteuerschaltung und der Synchrongleichrichter sind vorzugsweise auf zumindest einer Platine angeordnet, welche Platine an der Innenfläche zumindest einer Kontaktplatte angeordnet ist. Durch diese Anordnung der Ansteuerschaltung und des Synchrongleichrichters an der Innenseite zumindest einer Kontaktplatte kann eine direkte, also leitungslose, Kontaktierung der Anschlüsse der Sekundärwicklungen mit den Schaltelementen des Synchrongleichrichters und auch eine direkte, bzw. leitungslose, Kontaktierung der Ausgänge des Synchrongleichrichters mit der Kontaktplatte erreicht werden. Vorzugsweise ist der Hochstromtransformator bzw. die Stromquelle zur Bereitstellung des Schweißstroms symmetrisch aufgebaut, wobei beiderseits der symmetrisch angeordneten Sekundärwicklungen jeweils eine Platine mit einem Teil des Synchrongleichrichters und der Ansteuerschaltung unterhalb jeweils einer Kontaktplatte angeordnet ist.

Jede Platine des Synchrongleichrichters und der Ansteuerschaltung weist vorzugsweise Öffnungen auf, über welchen die Schaltelemente angeordnet sind, und die Innenfläche der Kontaktplatten weisen an den Stellen der Öffnungen in der Platine des Synchrongleichrichters Ausbuchtungen, insbesondere zinnenförmige Ausbuchtungen, auf, sodass die Schaltelemente über die durch die Öffnungen der Platine ragenden Ausbuchtungen an der Innenfläche der Kontaktplatten leitungslos kontaktierbar sind. Auf diese Weise kann auf Verbindungsleitungen zwischen den Schaltelementen des Synchrongleichrichters und den Kontaktplatten verzichtet werden, wodurch einerseits die Ohm'schen Verluste reduziert werden können und andererseits der thermische Übergang zwischen den Schaltelementen und den Kontaktplatten verbessert werden kann. Schließlich wird auch der Herstellungsaufwand verringert, da keine Verbindungsleitungen verlegt und angeschlossen werden müssen, sondern die Schaltelemente direkt mit den Ausbuchtungen verbunden, vorzugsweise verlötet werden. Auch kann über die Ausbuchtungen eine einfache Positionierung der Platine ermöglicht und somit die Herstellung wesentlich vereinfacht werden.

Von Vorteil ist auch eine Ausgestaltung, bei der die Source-Anschlüsse der durch Feldeffekttransistoren gebildeten Schaltelemente über die Ausbuchtungen, insbesondere zinnenförmigen Ausbuchtungen, direkt mit der Kontaktplatte elektrisch und thermisch verbunden sind, da hier wiederum die entsprechenden Leitungen vermieden werden können.

Jede Platine ist vorzugsweise zur Bildung der notwendigen elektrischen Isolierung zwischen dem I-Träger und den Kontaktplatten angeordnet. Auf diese Weise ist es nicht erforderlich eine gesonderte elektrische Isolierung zwischen dem I-Träger und den Kontaktplatten vorzusehen.

Die Erfindung wird anhand der beigefügten Zeichnungen näher erläutert.

Darin zeigen:
- Fig. 1: eine Widerstandsschweißvorrichtung des Standes der Technik mit einem Roboter und daran befestigter Schweißzange in schematischer Darstellung;
- Fig. 2: ein schematisches Blockschaltbild einer Widerstandsschweißvorrichtung mit einer Stromquelle zur Bereitstellung des Schweißstroms;
- Fig. 3: eine Widerstandsschweißvorrichtung, insbesondere eine Schweißzange, mit einer integrierten Stromquelle zur Bereitstellung des Schweißstroms in schematischer Darstellung;
- Fig. 4: ein schematisches Blockschaltbild der Stromquelle zur Bereitstellung des Schweißstroms;
- Fig. 5: eine Ausführungsform der Stromquelle zur Bereitstellung eines Gleichstroms;
- Fig. 6: die Stromquelle gemäß Fig. 5 in Explosionsdarstellung;
- Fig. 7: die Stromquelle gemäß Fig. 5 mit eingezeichnetem Verlauf der Kühlkanäle;
- Fig. 8: eine Ansicht auf den I-Träger des Hochstromtransformators der Stromquelle;
- Fig. 9: der I-Träger gemäß Fig. 8 in geschnittener Darstellung;
- Fig. 10: eine Kontaktplatte des Hochstromtransformators der Stromquelle samt Platine des Synchrongleichrichters und der Ansteuerschaltung;
- Fig. 11: die Kontaktplatte gemäß Fig. 10 in geschnittener Darstellung;
- Fig. 12: eine Sekundärwicklung des Hochstromtransformators mit Stromwandler in Explosionsdarstellung;
- Fig. 13: der Aufbau einer Sekundärwicklung des Hochstromtransformators in Explosionsdarstellung;
- Fig. 14: ein Blockschaltbild einer Schaltung zur Versorgung des Synchrongleichrichters und der Ansteuerschaltung mit elektrischer Energie;
- Fig. 15: ein Zeitverlauf der Versorgungsspannung der Versorgungsschaltung gemäß Fig. 14; und
- Fig. 16: Zeitverläufe zur Veranschaulichung der Ansteuerung der Schaltelemente eines Synchrongleichrichters in Abhängigkeit der sekundärseitigen Ströme des Hochstromtransformators.

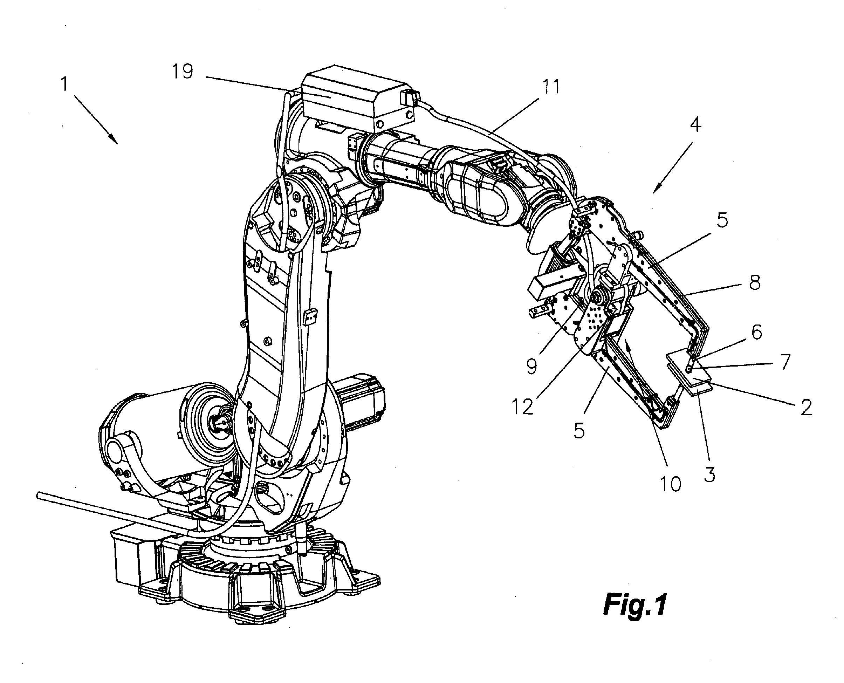

Bei dem dargestellten Ausführungsbeispiel der Fig. 1 bis 16 wird ein Aufbau einer Widerstandsschweißvorrichtung 1 mit den wesentlichen Komponenten beschrieben. Für die gleichen Teile wurden in den Figuren gleiche Bezugszeichen vergeben.

In Fig. 1 ist eine Widerstandsschweißvorrichtung 1 zum Widerstandsschweißen von zumindest zwei Werkstücken 2, 3 mit einem Roboter zur Manipulation perspektivisch dargestellt. Die Widerstandsschweißvorrichtung 1 besteht aus einer am Roboter befestigten Schweißzange 4 mit zwei Zangenarmen 5, an welchen Aufnahmen 6 zur Aufnahme jeweils einer Elektrode 7 angeordnet sind. Um die Elektroden 7 verläuft jeweils ein Band 8, welches den Übergangswiderstand bei der Widerstandsschweißung reduziert und die Elektroden 7 schützt. Darüber hinaus kann die am Band 8 entstehende Abbildung des hergestellten Schweißpunkts analysiert und zur Beurteilung der Schweißqualität herangezogen werden. Das Band 8 zum Schutz der Elektroden 7 wird von einer Wickelvorrichtung 9, welche an der Schweißzange 4 bzw. den Zangenarmen 5 angeordnet sein kann, abgerollt und entlang der Zangenarme 5, der Elektrodenaufnahmen 6 und der Elektroden 7 wieder zurück zur Wickelvorrichtung 9, wo das Band 8 wieder aufgerollt wird, geführt. Zur Durchführung der Punktschweißung wird der Schweißstrom, welcher von einem entsprechenden Leistungsteil 19 geliefert wird, durch die Elektroden 7 geleitet. Dadurch werden die Werkstücke 2, 3 durch einen beim Punktschweißvorgang entstehenden Schweißpunkt miteinander verbunden. Üblicherweise befindet sich das Leistungsteil 19 zur Bereitstellung des Schweißstroms außerhalb der Widerstandsschweißvorrichtung 1, wie schematisch in Fig. 1 dargestellt. Der Schweißstrom wird über entsprechende Leitungen 11 zu den Elektroden 7 bzw. den elektrisch leitend ausgebildeten Zangenarmen 5 geführt. Aufgrund der Amplitude des Schweißstroms im Bereich von einigen kA sind entsprechend große Querschnitte für die Leitungen 11 erforderlich, wodurch entsprechend hohe Ohm'sche Verluste resultieren.

Darüber hinaus führen lange Primärzuleitungen zu einer erhöhten Induktivität der Leitungen 11, weshalb die Schaltfrequenz, mit welcher ein Hochstromtransformator 12 einer Stromquelle 10 betrieben wird, begrenzt sind, resultierend in sehr großen Hochstromtransformatoren 12. Beim Stand der Technik befindet sich das Leistungsteil 19 in einem Schaltschrank neben dem Schweißroboter, sodass sehr lange Versorgungsleitungen, beispielsweise bis zu 30m, zum Hochstromtransformator 12 für die Schweißzange 4 am Roboter erforderlich sind.

Bei der erfindungsgemäßen Lösung wird eine erhebliche Gewichts- und Größenreduktion erzielt, sodass eine Positionierung des Leistungsteils 19 direkt am Roboter, insbesondere im Bereich der Zangenaufnahme, ermöglicht wird. Zusätzlich wird das Leistungsteil 19 vorzugsweise wassergekühlt ausgeführt.

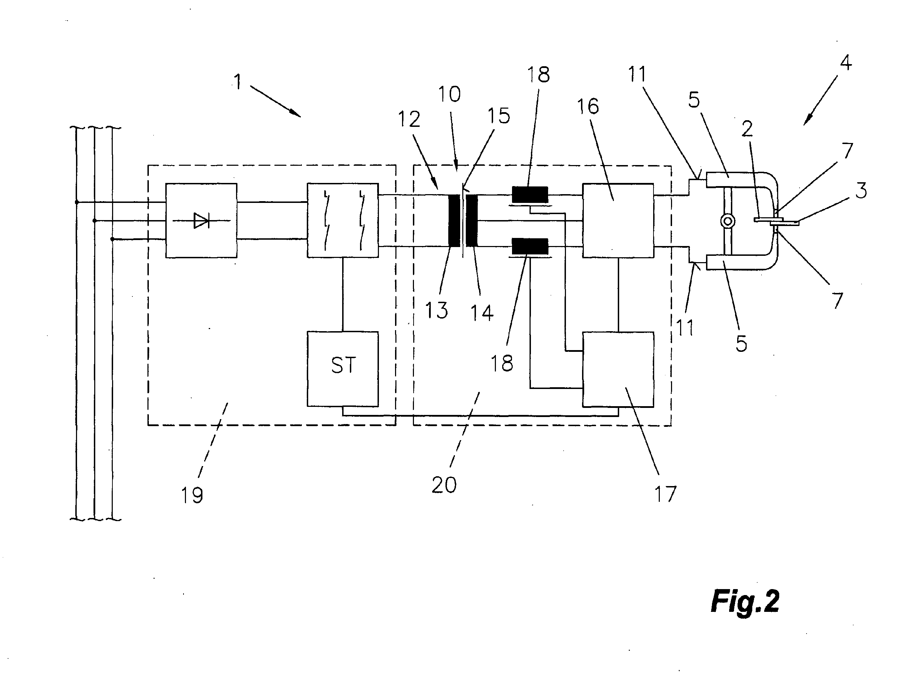

Fig. 2 zeigt ein schematisches Blockschaltbild einer Widerstandsschweißvorrichtung 1 mit einer Stromquelle 10 zur Bereitstellung des Schweißstroms. Obgleich im dargestellten Ausführungsbeispiel die Stromquelle 10 zur Bereitstellung des Schweißstroms für die Widerstandsschweißvorrichtung 1 dient, kann die Stromquelle 10, insbesondere der gesamte Aufbau der Stromversorgung, auch zur Bereitstellung eines Gleichstroms für andere Anwendungen herangezogen werden. Die Stromquelle 10 beinhaltet einen Hochstromtransformator 12 mit zumindest einer Primärwicklung 13, zumindest einer Sekundärwicklung 14 mit Mittelanzapfung und einem Ringkern 15. Der mit Hilfe des Hochstromtransformators 12 transformierte Strom wird in einem Synchrongleichrichter 16 gleichgerichtet und den Zangenarmen 5 bzw. Elektroden 7 der Widerstandsschweißvorrichtung 1 zugeführt. Zur Steuerung des Synchrongleichrichters 16 ist eine Ansteuerschaltung 17 vorgesehen. Die Ansteuerschaltung 17 sendet entsprechende Steuerimpulse an die Schaltelemente 24 des Synchrongleichrichters 16 aufgrund der beispielsweise über Stromwandler 18 gemessenen sekundärseitigen Ströme des Hochstromtransformators 12.

Wie allgemein bekannt ist, treten aufgrund der hohen Schweißströme durch die Summe der erforderlichen Leitungslänge sowohl erhebliche Ohm'sche und/oder induktive Verluste als auch Durchlass- und Schaltverluste in den Schaltelementen 24 des Synchrongleichrichters 16 auf. Daneben treten auch im Gleichrichter, in der Versorgung für den Synchrongleichrichter 16 und die Ansteuerschaltung 17 Verluste auf. Dementsprechend niedrig ist der resultierende Wirkungsgrad derartiger Widerstandsschweißvorrichtungen 1.

Zur Erzeugung des primärseitigen Stroms des Hochstromtransformators 12 ist ein Leistungsteil 19 vorgesehen, welches zwischen einem Versorgungsnetz und der Stromquelle 10 angeordnet ist. Das Leistungsteil 19 stellt den primärseitigen Strom für den Hochstromtransformator 12 bzw. die Stromquelle 10 mit der gewünschten Amplitude und gewünschten Frequenz zur Verfügung.

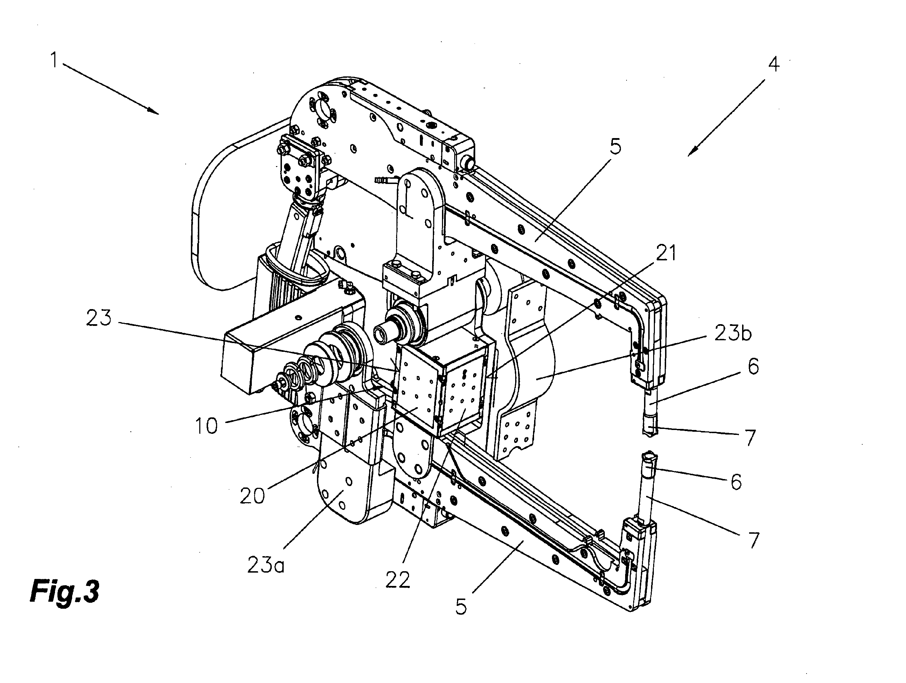

Fig. 3 zeigt eine Widerstandsschweißvorrichtung 1 mit integrierter Stromquelle 10 in schematischer Darstellung. Dabei ist die Stromquelle 10 direkt, insbesondere als tragendes Element, an der Schweißzange 4 bzw. den Zangenarmen 5 der Widerstandsschweißvorrichtung 1 angeordnet, so dass zumindest ein Teil der Leitungen 11 zur Führung des Schweißstroms zu den Elektroden 7 entfallen kann und somit die Leitungslängen wesentlich verkürzt werden, da nur noch die Verbindung mit einem Zangenarm 5 erforderlich ist. Die Stromquelle 10 weist zur Bildung einer Mehrpunktkontaktierung zumindest vier Kontakte 20, 21, 22, 23 auf, wobei zwei erste Kontakte 20, 21 einer Polarität mit dem einen Zangenarm 5 und zwei weitere Kontakte 22, 23 einer entgegengesetzten Polarität mit dem anderen Zangenarm 5 verbunden sind. Vorteilhafterweise sind die zwei ersten Kontakte 20, 21 mit der einen Polarität und die zwei weiteren Kontakte 22, 23 mit der anderen Polarität jeweils gegenüberliegend angeordnet, wobei die zwei weiteren Kontakte 22, 23 gegenüber den zwei ersten Kontakten 20, 21 im Wesentlichen um 90° zueinander versetzt angeordnet sind. Durch die Mehrpunktkontaktierung können Leitungen, die üblicherweise zum Verbinden der Sekundärseite 14 des Hochstromtransformators 12 mit den Zangenarmen 5 bzw. den Elektroden 6 der Widerstandsschweißvorrichtung 1 erforderlich sind, vermieden oder deren Länge verringert werden und somit die Ohm'schen Verluste wie auch Kontaktverluste deutlich reduziert werden. Somit können möglichst kurze Leitungen mit möglichst großen Querschnitten eingesetzt werden, wobei gleichzeitig die Flexibilität der Schweißzange 4 erhalten bleibt. Ein weiterer Vorteil liegt darin, dass aufgrund einer derartigen Kontaktierung die Verluste, insbesondere Kontaktübergangswiderstände, reduziert werden. Aufgrund der mindestens vier Kontakte 20, 21, 22, 23 kann der zu übertragende Schweißstrom halbiert werden, wodurch auch eine Reduktion der Übergangsverluste bewirkt wird, da durch die wesentliche Vergrößerung der aktiven Kontaktflächen die Übergangswiderstände reduziert werden. Beispielsweise weist jeder der vier Kontakte 20, 21, 22, 23 bei der Dimensionierung eines Hochstromtransformators 12 bzw. einer Stromquelle 10 zur Bereitstellung eines Gleichstroms von 20kA eine Fläche zwischen 15cm x 15cm bis 25cm x 25cm, bevorzugt 20cm x 20cm, auf.

Im dargestellten Ausführungsbeispiel ist die Stromquelle 10 im Wesentlichen Würfelförmig ausgebildet, wobei die Seitenfläche des Würfels die Kontakte 20, 21, 22, 23 bilden. Die beiden ersten Kontakte 20, 21 werden mit der einen Elektrode 7 und die beiden weiteren Kontakte 22, 23 mit der anderen Elektrode 7 der Widerstandsschweißvorrichtung 1 über die Zangenarme 5 verbunden. Wie aus der teilweise Explosionsdarstellung ersichtlich, wird zumindest ein Zangenarm 5, insbesondere der untere Zangenarm 5, über ein tragendes Element 23a des unteren Zangenarms 5 verbunden, wogegen der weitere, insbesondere der obere Zangenarm 5 über eine flexible Verbindungsschelle 23b mit den weiteren Kontakten 22, 23 verbunden ist. Zumindest ein Zangenarm 5 ist also direkt mit dem Hochstromtransformator 12 und der weitere Zangenarm 5 über eine sehr kurze Leitung, beispielsweise kürzer als 50cm, mit diesem verbunden. Dadurch, dass die Leitungen 11 zwischen der Stromquelle 10 und den Elektroden 7 bzw. den Zangenarmen 5 der Widerstandsschweißvorrichtung 1 wegfallen bzw. besonders kurz ausfallen, können die Ohm'schen und induktiven Verluste deutlich reduziert werden.

Besondere Vorteile ergeben sich dann, wenn zumindest zwei Kontakte 20, 21 direkt bzw. leitungslos und somit ohne Kontaktübergangswiderstände mit einem Zangenarm 5 verbunden werden. Dies kann dadurch erzielt werden, dass in der Stromquelle 10 diese beiden Kontakte 20, 21 quasi integriert sind, welche mit den entsprechenden Teilen der Widerstandsschweißvorrichtung 1, insbesondere den Zangenarmen 5, direkt, also ohne Verlegung von Leitungen, verbunden werden. Durch das direkte Verbinden eines Zangenarms 5 mit den Kontakten 20, 21 des Hochstromtransformators 12 wird somit eine leitungslose Verbindung erreicht, wogegen der zweite Zangenarm 5 mit sehr kurzen Leitungen mit den Kontakten 22, 23 verbunden werden muss. Hiermit kann eine sehr hohe Reduktion der Leitungsverluste erzielt werden, da die Leitungslänge auf das Minimum reduziert werden. Beim Stand der Technik wird im optimalen Fall der Hochstromtransformator möglichst nahe an der Schweißzange 4 positioniert, sodass anschließend vom Hochstromtransformator 12 zur Schweißzange 4 die Leitungen verlegt werden müssen, wogegen bei der erfindungsgemäßen Lösung der Hochstromtransformator 12 in der Schweißzange 4 integriert ist und gleichzeitig ein Zangenarm 5 direkt am Hochstromtransformator 12 befestigt ist, sodass nur noch der zweite Zangenarm 5 mit einer bzw. zwei kurzen Leitungen angeschlossen werden muss. Selbstverständlich können anstelle von Leitungen auch beispielsweise Schleifkontakte oder andere Verbindungselemente verwendet werden. Auch die Verluste innerhalb der Stromquelle 10 können aufgrund der kompakten Bauweise und der direkten, also leitungslosen, Verbindung der Komponenten der Stromquelle 10 deutlich verringert werden.

Vorteilhafterweise sind sämtliche Komponenten der Stromquelle 10, so auch der Synchrongleichrichter 16, die Ansteuerschaltung 17, die Stromwandler 18 und sämtliche Versorgungsschaltungen für den Synchrongleichrichter 16 und die Ansteuerschaltung 17 in der Würfel- bzw. Quaderförmigen Einheit enthalten. Dass heißt, dass durch die Integration der elektronischen Komponenten/Schaltungen eine Baueinheit in Form eines Würfel geschaffen wird, an dem der Benutzer primärseitig nur noch Energie in Form entsprechender Wechselspannung bzw. entsprechenden Wechselstroms bereitstellen muss, um sekundärseitig einen entsprechend dimensionierten Gleichstrom bzw. eine entsprechend dimensionierte Gleichspannung mit hoher Leistung zu erhalten. Die Steuerung und Regelung wird autark im Würfel bzw. der Stromquelle 10 durchgeführt. Damit ist der Würfel bzw. die Stromquelle 10 vielseitig zur Versorgung von Komponenten mit hohem Gleichstrom anwendbar. Insbesondere dient die Stromquelle 10 zur Versorgung mit geringer Spannung und hohem Strom, wie dies bei Widerstandsschweißprozessen üblich ist.

Beim Einsatz in einem Widerstandsschweißprozess können auch Teile der Würfelförmig ausgebildeten Stromquelle 10 durch Komponenten der Widerstandsschweißvorrichtung 1, beispielsweise Teile der Zangenarme 5 oder dergleichen, gebildet sein, wie dies dargestellt ist. Dabei übernimmt der Würfel bzw. die Stromquelle 10 eine tragende Funktion, indem ein Zangenarm 5 direkt am Würfel befestigt ist. Der weitere Zangenarm 5 wird über Verbindungsleitungen (nicht dargestellt) kontaktiert. Durch diesen Aufbau können lange Zuleitungen verhindert werden, sodass eine wesentliche Reduktion der Verluste erreicht wird. Damit der Würfel jedoch in eine derartige Schweißzange 4 integriert werden kann, ist es erforderlich, dass dessen Baugröße möglichst gering gehalten wird. Beispielsweise weist der Würfel bzw. die Stromquelle 10 bei einer Dimensionierung des hbereitzustellenden Gleichstroms von bis zu 20kA eine Seitenlänge zwischen 10cm und 20cm, insbesondere 15cm, auf. Durch diese kompakte Ausgestaltung der Würfelförmigen Stromquelle 10 ist es leicht möglich, diese beispielsweise im Grundkörper der Schweißzange 4 zu integrieren.

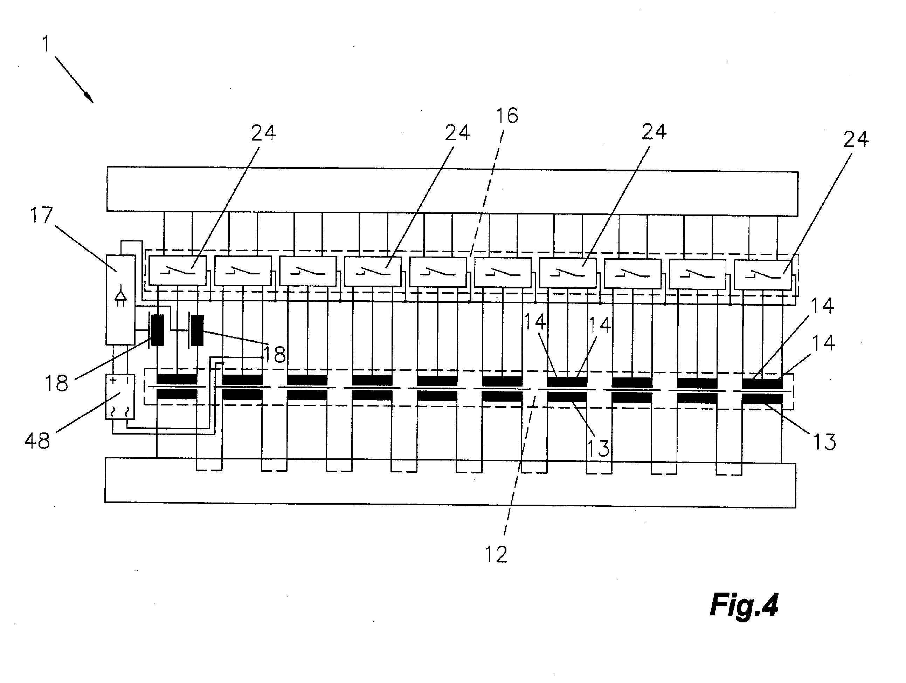

Fig. 4 zeigt ein schematisches Blockschaltbild der Stromquelle 10 zur Bereitstellung eines Gleichstroms, insbesondere eines Schweißstroms. Bei dieser bevorzugten Ausführungsvariante der Stromquelle 10 sind zehn Primärwicklungen 13 des Hochstromtransformators 12 in Serie geschaltet und zehn Sekundärwicklungen 14 des Hochstromtransformators 12 mit Mittelanzapfung parallel geschaltet. Durch eine derartige Ausführung des Hochstromtransformators 12 kann das entsprechend hohe Übersetzungsverhältnis zur Erzielung eines entsprechend hohen sekundärseitigen Stroms auch bei geringen Windungszahlen der Primärwicklungen 13 und geringen Windungszahlen der Sekundärwicklungen 14 erzielt werden. Beispielsweise kann mit zehn Primärwicklungen 13 und ebenfalls zehn Sekundärwicklungen 14 ein Übersetzungsverhältnis von 100 erreicht werden. Der Primärstrom durchfließt die in Serie geschalteten Primärwicklungen 13 des Hochstromtransformators 12, wohingegen der relativ hohe sekundärseitige Strom auf die zehn parallel geschalteten Sekundärwicklungen 14 aufgeteilt wird. Die sekundärseitigen Teilströme werden den entsprechenden Schaltelementen 24 des Synchrongleichrichters 16 zugeführt. Durch eine derartige Aufteilung ergibt sich trotz geringer primär- und sekundärseitiger Windungszahlen ein entsprechend hohes Übersetzungsverhältnis (hier 100). Durch diese Konstruktion sind im Gegensatz zu herkömmlichen Hochstromtransformatoren primärseitig geringere Windungszahlen erforderlich, wodurch die Länge der Primärwicklung 13 verringert werden kann und dadurch die Ohm'-schen Verluste reduziert werden können. Durch die reduzierte Windungszahl der Primärwicklung 13 und somit eine daraus resultierende Reduktion der Leitungslänge ist wiederum die systemtypische Streuinduktivität des Hochstromtrafos 12 verringert, wodurch der Hochstromtransformator 12 mit höheren Schaltfrequenzen, beispielsweise 10kHz, betrieben werden kann. Die gegenüber herkömmlichen Hochstromtransformatoren höheren Schaltfrequenzen bewirken wiederum eine Verringerung der Baugröße und des Gewichts des Hochstromtransformators 12 und somit vorteilhafte Einbaumöglichkeiten. Damit kann der Hochstromtransformator 12 beispielsweise sehr nahe an die Elektroden 7 einer Widerstandsschweißvorrichtung 1 positioniert werden. Somit kann auch die Traglast des Schweißroboters aufgrund des geringen Gewichts des Hochstromtransformators 12 verringert werden, sodass mit einem kleinen billigeren Schweißroboter das Auslangen gefunden werden kann.

Herkömmliche Transformatoren, bei denen keine Serien-/ParallelSchaltung der Primär- und Sekundärwicklung erfolgt, würden entsprechend mehr Primärwindungen erfordern, was wesentlich längere primärseitige Drahtlängen zur Folge hätte. Aufgrund der größeren Drahtlänge steigen einerseits die Ohm'schen Verluste und resultiert andererseits eine höhere Streuinduktivität, weshalb die Frequenzen, mit welchen der Transformator aus dem Stand der Technik betrieben werden kann, mit einigen kHz begrenzt sind.

Im Gegensatz dazu sind bei der hier beschriebenen Konstruktion des Hochstromtransformators 12 die Ohm'schen Verluste und die systembedingte Streuinduktivität der Primärwicklungen 13 und Sekundarwicklungen 14 gering, weshalb Frequenzen im Bereich von 10kHz und darüber verwendet werden können. Dadurch wiederum kann eine wesentlich kleinere Baugröße des Hochstromtransformators 12 erzielt werden. Die kleinere Baugröße des Hochstromtransformators 12 bzw. der Stromquelle 10 ermöglicht es wiederum, diesen bzw. diese näher an den Ort, wo der erzeugte Strom benötigt wird, anzuordnen, beispielsweise an den Zangenarmen 5 einer Widerstandsschweißvorrichtung 1.

Durch die Parallelschaltung der Sekundärwicklungen 14 des Hochstromtransformators 12 wird der resultierende, hohe sekundärseitige Strom auf mehrere Teilströme aufgeteilt. Diese Teilströme werden an Schaltelemente 24 des Synchrongleichrichters 16 weitergeleitet, wie dies schematisch dargestellt ist. Zum Aktivieren der Schaltelemente 24 ist eine Ansteuerschaltung 17, die im Bereich der Primärwicklung 13 und Sekundärwicklung 14 eingezeichnet ist, vorgesehen, wobei sowohl der Synchrongleichrichter 16, als auch die Ansteuerschaltung 17 mit dazugehöriger Sensorik innerhalb des Würfels, also innerhalb des Hochstromtransformators 12, angeordnet sind. Der Synchrongleichrichter 16 und die Ansteuerschaltung 17 sind dabei derart ausgebildet und dimensioniert, dass diese autark, also ohne Einfluss von außen, die Regelung und Steuerung der Stromquelle 10 durchführen. Der Würfel weist daher bevorzugt keine Steuerleitungen zum Eingriff von außen auf, sondern lediglich Anschlüsse bzw. Kontakte für die primärseitige Versorgung und Anschlüsse bzw. Kontakte für die Lieferung der erzeugten sekundärseitigen Energie, insbesondere des hohen sekundären Gleichstroms.

Es ist jedoch möglich, dass ein entsprechender Anschluss der Ansteuerschaltung 17 herausgeführt wird, um der Ansteuerschaltung 17 Sollwerte vorgeben zu können. Durch externe Anpassungen kann die Stromquelle 10 optimal auf das Einsatzgebiet abgestimmt werden. Wie aus dem Stand der Technik bekannt, können jedoch Systeme zum Verändern oder Übertragen von Daten eingesetzt werden, die drahtlos, vorzugsweise induktiv, magnetisch oder per Bluetooth arbeiten, sodass kein Steueranschluss herausgeführt werden muss.

Die Steuerung und/oder Regelung der Stromquelle 10 erfolgt über die integrierte Sensorik. Über die Messung der sekundärseitigen Ströme einer Sekundärwicklung 14 mit Hilfe entsprechender Stromwandler 18 erhält die Ansteuerschaltung 17 die Information, zu welchen Zeitpunkten die Schaltelemente 24 des Synchrongleichrichters 16 geschaltet werden sollen. Dadurch, dass die Stromwandler 18 nur einen Bruchteil, hier ein Zehntel, des sekundärseitigen Stroms des Hochstromtransformators 12 messen, können sie kleiner ausgeführt werden, was sich wieder auf die Baugröße der Stromquelle 10 positiv auswirkt.

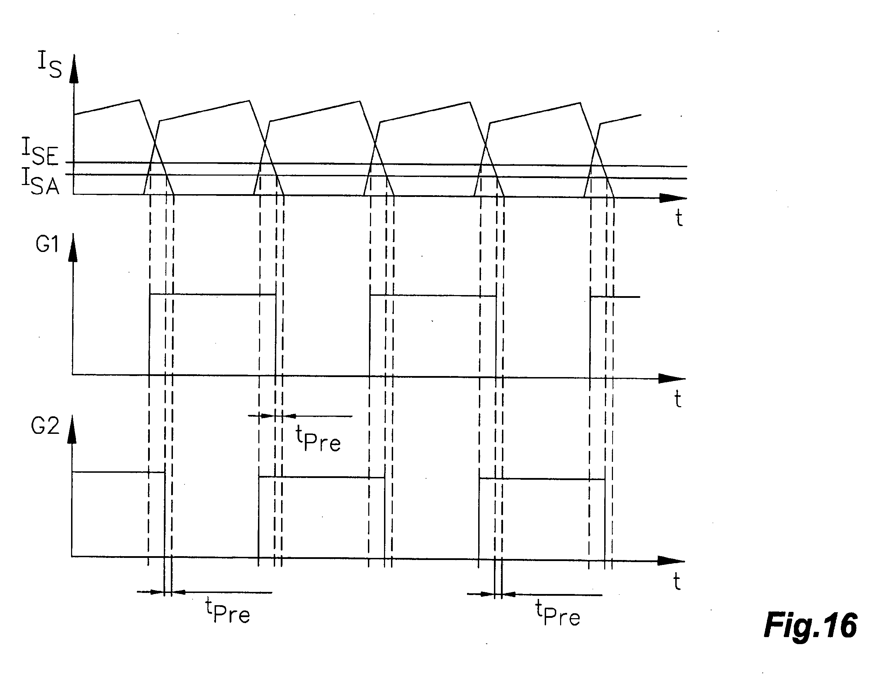

Zur Verringerung der Durchlassverluste und Schaltverluste werden die Schaltelemente 24 des Synchrongleichrichters 16 möglichst im Nulldurchgang der sekundärseitigen Ströme durch die Sekundärwicklungen 14 des Hochstromtransformators 12 geschaltet. Da es von der Erfassung des Nulldurchgangs des sekundärseitigen Stroms durch die Stromwandler 18 bis zur Aktivierung der Schaltelemente 24 des Synchrongleichrichters 16 zu gewissen Verzögerungen kommt, ist die Ansteuerschaltung 17 erfindungsgemäß dazu ausgebildet die Schaltelemente 24 des Synchrongleichrichters 16 zu einem voreingestellten Zeitpunkt vor dem Erreichen des Nulldurchgangs des Stroms in der Sekundärwicklung 14 zu schalten. Die Ansteuerschaltung 17 bewirkt also die Schaltung der Schaltelemente 24 des Synchrongleichrichters 16 zu einem Zeitpunkt, zu welchen die durch die Stromwandler 18 gemessenen Ströme in der Sekundärwicklung 14 des Hochstromtransformators 12 eine bestimmte Einschalt- und Ausschaltschwelle unterschreiten bzw. überschreiten. Durch diese Maßnahme kann erreicht werden, dass die Schaltelemente 24 des Synchrongleichrichters 16 im Wesentlichen während des Nulldurchgangs der Ströme durch die Sekundärwicklung 14 des Hochstromtransformators 12 geschaltet werden, wodurch die Durchlassverluste und Schaltverluste minimiert werden können (siehe auch Fig. 16).

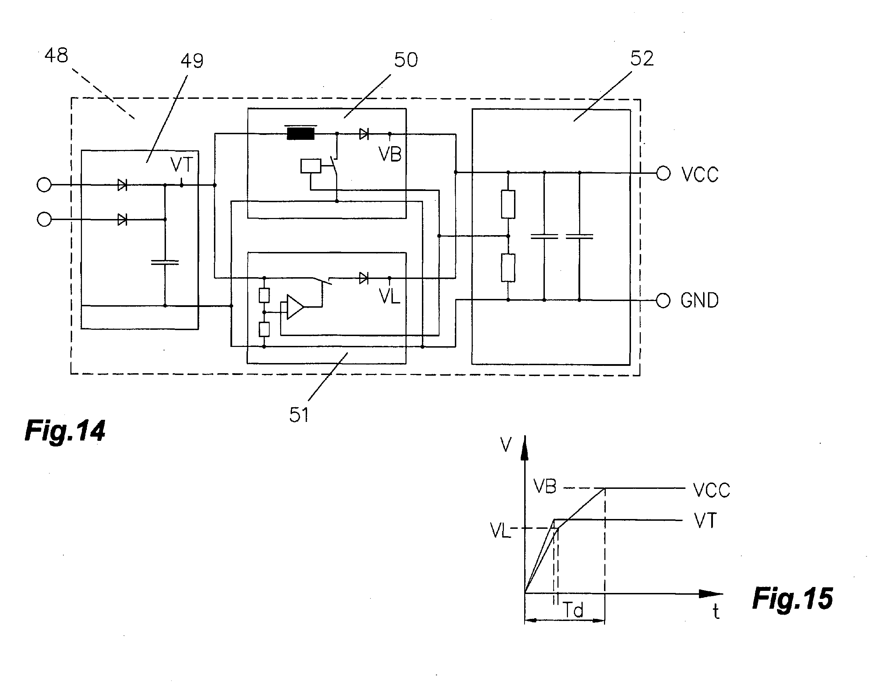

Für eine Primärwicklung 13 und Sekundärwicklung 14 ist in Fig. 4 auch die Versorgungsschaltung 48 zur Versorgung des Synchrongleichrichters 16 und der Ansteuerschaltung 17 mit elektrischer Energie eingezeichnet. Auch diese Versorgungsschaltung 48 ist vorzugsweise in der Stromquelle 10, also im Würfel, integriert. Da die Versorgung des Synchrongleichrichters 16 und der Ansteuerschaltung 17 der Stromquelle 10 mit ausreichender elektrischer Energie zum gewünschten Zeitpunkt der Lieferung des Gleichstroms, beispielsweise des Schweißstroms, gewährleistet sein muss, ist eine ausreichend rasche Aktivierung der Versorgungsschaltung 48 erforderlich (siehe Fig. 15) bzw. ist diese derart ausgelegt, dass bei Aktivierung der Stromquelle 10 so schnell wie möglich eine ausreichend hohe Versorgungsspannung zur Verfügung steht und anschließend die benötigte Leistung bzw. der benötigte Strom geliefert wird.

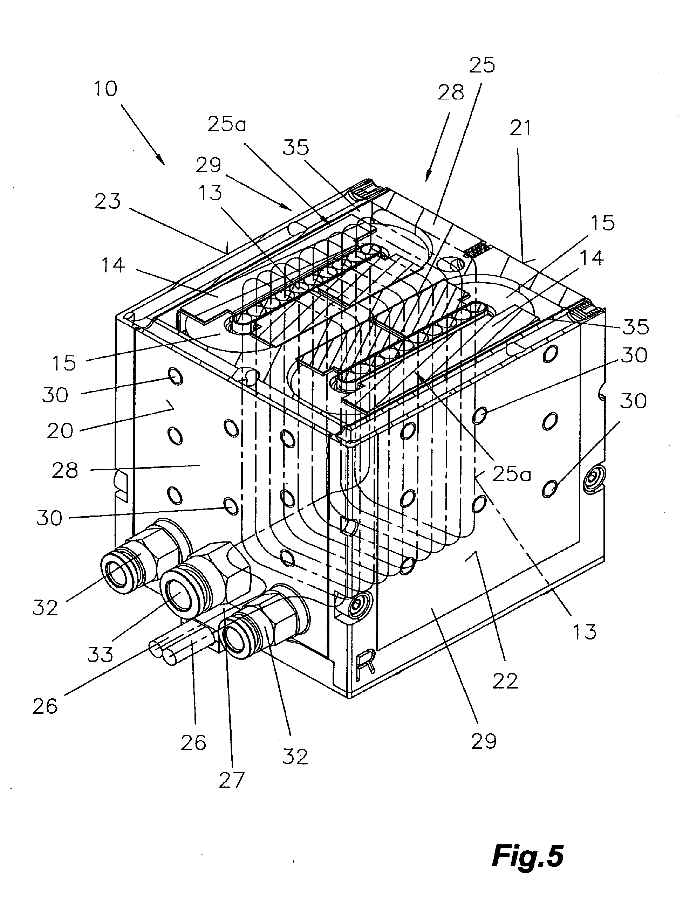

Fig. 5 zeigt die Ausführungsform der Stromquelle 10 gemäß Figur 3 in vergrößerter Darstellung. Die Stromquelle 10 zur Bereitstellung eines Gleichstroms, beispielsweise Schweißstroms, weist im Wesentlichen die Form eines Würfels bzw. Quaders auf, wobei die Seitenflächen des Würfels bzw. Quaders die Kontakte 20, 21, 22, 23 darstellen, über welche der erzeugte Gleichstrom zum entsprechenden Verbraucher, beispielsweise die Zangenarme 5 bzw. Elektroden 7 einer Widerstandsschweißvorrichtung 1, weitergeleitet werden kann. Sämtliche Komponenten der Stromquelle 10, also der Hochstromtransformator 12, der Synchrongleichrichter 16, die Ansteuerschaltung 17, die Stromwandler 18, die Versorgungsschaltung 48, usw. sind in diesem Würfel- bzw. Quaderförmigen Element der Stromquelle 10 enthalten bzw. integriert. Durch diese kompakte Bauweise können die Verluste der Stromquelle 10 besonders gering gehalten werden und somit deren Wirkungsgrad deutlich erhöht werden, da eine optimale Verkürzung der Leitungen und somit der Schaltzeiten mit der Integration der elektronischen Komponenten, insbesondere der Platinen mit dem Synchrongleichrichter 16, der Ansteuerschaltung 17 und der Versorgungsschaltung 48, im Würfel erzielt wird. Durch die Integration des Synchrongleichrichters 16 und die Ansteuerschaltung 17 sowie der Versorgungsschaltungen 48 der Stromquelle 10 im Hochstromtransformator 12 sowie Parallelschaltung mehrerer Schaltelemente 24 des Synchrongleichrichters 16 und leitungslose Verbindung der Schaltelemente 24 mit den Sekundärwicklungen 14 des Hochstromtransformators 12 sind keine Leitungen zwischen dem Synchrongleichrichter 16 und der Sekundärseite 14 des Hochstromtransformators 12 erforderlich, wodurch auch allfällige Ohm'sche Verluste und weitere Verluste durch derartige Leitungen wegfallen. Das Leistungsteil 19 für die Versorgung des Hochstromtransformators 12 wird möglichst nahe an diesem positioniert, um möglichst kurze Anschlussleitungen und somit Leitungsverluste und Leitungsinduktivitäten zu erreichen. Durch die Integration sämtlicher Komponenten wird eine autarke Einheit gebildet, welche eingangsseitig lediglich mit dem Leistungsteil 19 und ausgangsseitig - im Falle einer Widerstandsschweißvorrichtung 1 - mit den Zangenarmen 5 bzw. Elektroden 7 verbunden werden muss. Übliche Leitungen zwischen den einzelnen Schaltungen der Stromquelle 10 können entfallen oder zumindest deutlich in ihrer Länge reduziert werden.

Die Basis des Hochstromtransformators 12 der Stromquelle 10 bildet ein Transformatorelement in Form eines I-Trägers 25 aus elektrisch leitfähigem Material, insbesondere Kupfer oder einer Kupferlegierung, allenfalls mit einer Beschichtung, beispielsweise aus Silber. In den Ausnehmungen 25a des I-Trägers 25 werden beiderseits die Ringkerne 15 mit den Sekundärwicklungen 14 des Hochstromtransformators 12 angeordnet. Dabei ist es räumlich von Vorteil, wenn die Ringkerne 15 nicht kreisrunden, sondern ovalen bzw. flachen Querschnitt aufweisen. Im dargestellten Ausführungsbeispiel sind in jeder Ausnehmung 25a des I-Trägers 25 jeweils fünf Ringkerne 15 mit den jeweiligen Sekundärwicklungen 14 parallel angeordnet. Die Primärwicklung 13 bzw. die in Serie zusammengeschalteten Primärwicklungen 13 (strichpunktierte Linie) verlaufen durch die in den Ausnehmungen 25a des I-Trägers 25 angeordneten Ringkerne 15 und um den Mittelsteg des I-Trägers 25. Durch diesen Verlauf der Primärwicklung 13 durch die insbesondere symmetrisch in den beiden Ausnehmungen 25a des I-Trägers 25 angeordneten Ringkerne 15 kann eine optimale magnetische Kopplung zu den Sekundärwicklungen 14 erreicht werden. Die Anschlüsse 26 der Primärwicklung 13 werden über zumindest eine Öffnung 27 an einer Außenfläche 28 des I-Trägers 25 herausgeführt. Über diese Anschlüsse 26 kann die Primärwicklung 13 des Hochstromtransformators 12 mit dem entsprechenden Leistungsteil 19 verbunden werden. Die Außenflächen 28 des I-Trägers 25 bilden die beiden ersten Kontakte 20, 21 der Stromquelle 10, welche beispielsweise mit der einen Elektrode 7 der Widerstandsschweißvorrichtung 1 verbunden werden.

Über den Ausnehmungen 25a des I-Trägers 25 befinden sich Kontaktplatten 29, deren Außenflächen die beiden weiteren Kontakte 22, 23 der Stromquelle 10 bilden und gegenüber dem I-Träger 25 isoliert sind. Die Kontaktplatten 29 sind ebenfalls aus elektrisch leitfähigem Material, beispielsweise Kupfer oder einer Kupferlegierung, allenfalls mit einer Beschichtung, beispielsweise aus Silber, gebildet. Kupfer oder Kupferlegierungen weisen optimale elektrische Eigenschaften auf und zeigen gute Wärmeleitfähigkeit wodurch auftretende Wärmeverluste rascher abgeführt werden können. Die Silberbeschichtung verhindert eine Oxidation des Kupfers bzw. der Kupferlegierung. Anstelle von Kupfer oder Kupferlegierungen kommen auch Aluminium oder Aluminiumlegierungen in Frage, welche gegenüber Kupfer einen Gewichtsvorteil aufweisen, obgleich die Korrosionsbeständigkeit nicht so hoch ist. Anstelle einer Silberbeschichtung ist auch eine Beschichtung aus Zinn und anderen Materialien oder deren Verbindungen bzw. Schichten möglich. Zwischen den Kontaktplatten 29 und den entsprechenden Anschlüssen der Sekundärwicklungen 14 des Hochstromtransformators 12 sind die Platinen 35 des Synchrongleichrichters 16 und der Ansteuerschaltung 17 angeordnet. Diese Platinen 35 bzw. Leiterplatten sind direkt an die Kontaktplatten 29 montiert bzw. gelötet und werden anschließend am I-Träger 25 isoliert befestigt. Durch diese Bauweise können die sekundärseitigen Anschlüsse des Hochstromtransformators 12 direkt mit den Schaltelementen 24 des Synchrongleichrichters 16 verbunden bzw. kontaktiert werden, ohne dass Leitungen verlegt werden müssen. Die Ausgänge des Synchrongleichrichters 16 sind vorzugsweise ebenfalls direkt mit den Kontaktplatten 29 verbunden, wodurch keine Leitungen benötigt werden. Die Kontaktplatten 29 werden mit dem I-Träger 25 verbunden, vorzugsweise verschraubt (nicht dargestellt). An den Außenflächen 28 des I-Trägers 25 sowie den Außenflächen der Kontaktplatten 29 können Verbindungseinrichtungen 30, beispielsweise Bohrungen mit entsprechenden Gewinden zur Aufnahme von Schrauben, angeordnet sein. Über diese Verbindungseinrichtungen 30 können beispielsweise die Leitungen zu den Zangenarmen 5 einer Widerstandsschweißvorrichtung 1, oder anderen mit dem Gleichstrom zu versorgenden Geräten befestigt werden oder kann ein Zangenarm 5 direkt am I-Träger 25 oder an den Kontaktplatten 29 befestigt werden.

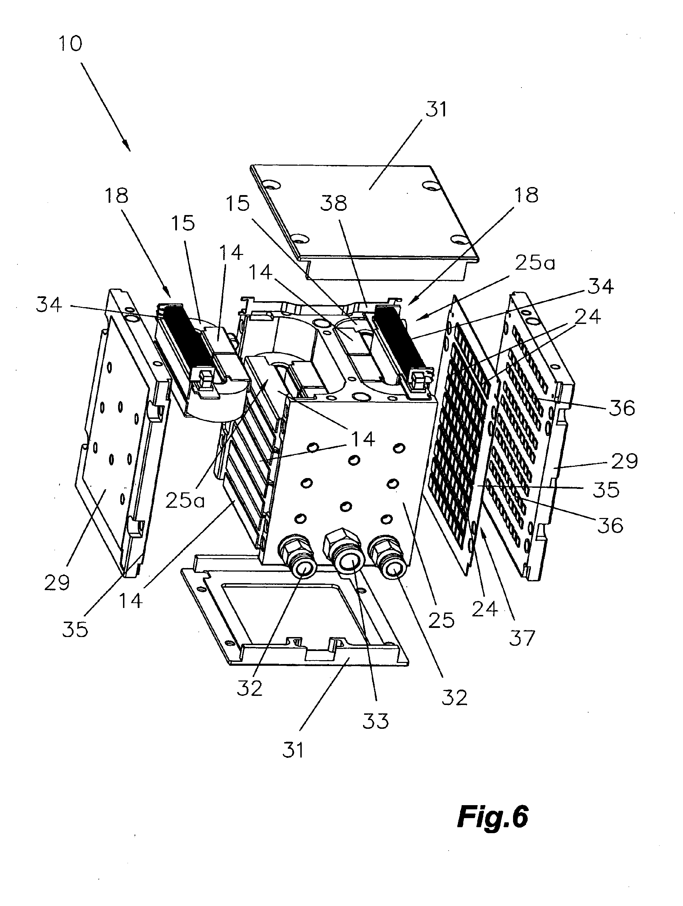

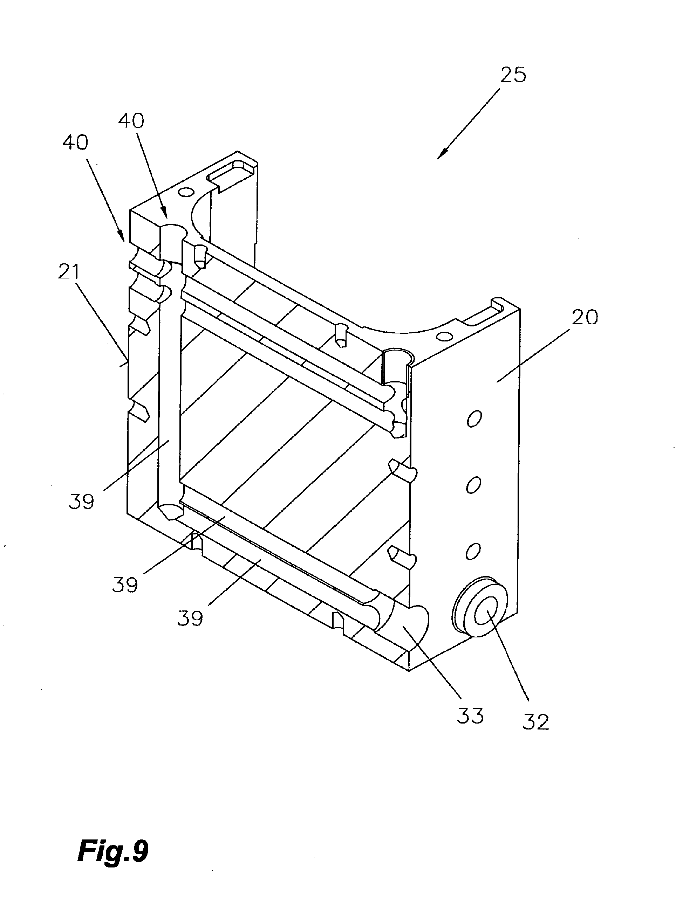

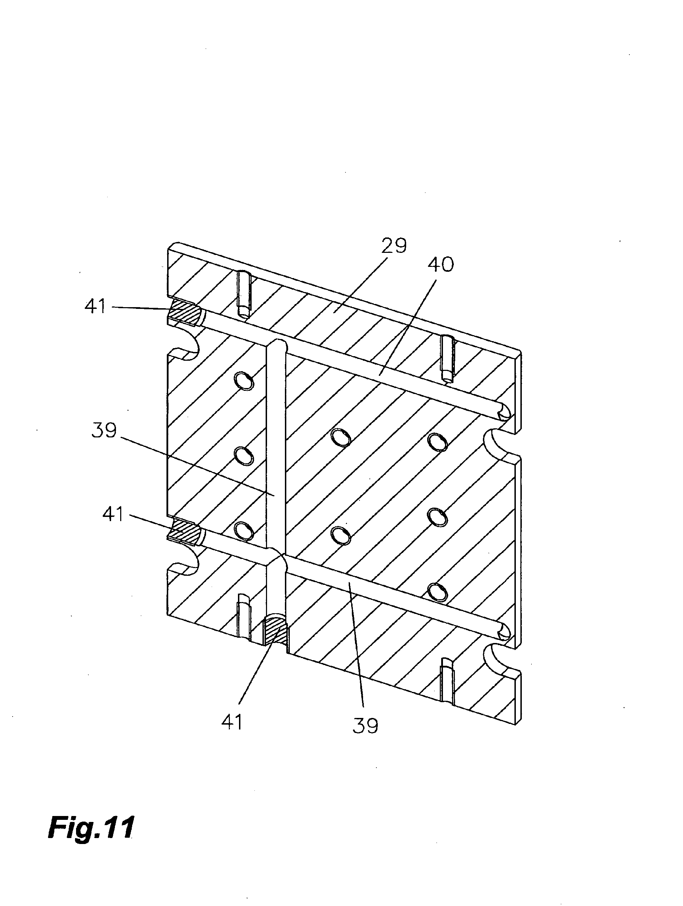

An der Oberseite und der Unterseite der Würfel- bzw. Quaderförmige Stromquelle 10 können Deckplatten 31 angeordnet und mit dem I-Träger 25 und den Kontaktplatten 29 verbunden, beispielsweise verschraubt, sein (siehe Fig. 6). Bevorzugt sind die Deckplatten 31 ebenfalls aus elektrisch leitfähigem Material gebildet und mit den Kontaktplatten 29 verschraubt, wodurch eine stabile Einheit des Hochstromtransformators 12 resultiert sowie über die Deckplatten 31 auch eine elektrische Verbindung zwischen den Kontaktplatten 29 hergestellt wird. Dadurch wird erreicht, dass über die Deckplatte 31 ein Ladungsausgleich stattfinden und es somit zu keinen unsymmetrischen Belastungen des Hochstromtransformators 12 kommen kann. Dadurch kann eine gesonderte elektrische Leitung, welche die beiden Kontaktplatten 29 elektrisch miteinander verbinden würde, entfallen, um den Spannungs- bzw. Potentialausgleich herzustellen und Unsymmetrien zu vermeiden. Über die Deckplatten 31 wird also die elektrische Verbindung der beiden Kontaktplatten 29 der symmetrischen Anordnung des Hochstromtransformators 12 bzw. der Stromquelle 10 zur Bereitstellung des Schweißstroms hergestellt. In diesem Fall muss natürlich eine entsprechende Isolierung zum I-Träger 25 gewährleistet sein. Die Deckplatten 31 sind so wie der I-Träger 25 und die Kontaktplatten 29 vorzugsweise aus Kupfer oder einer Kupferlegierung, vorzugsweise mit einer Silberbeschichtung, gebildet. An einer Außenfläche 28 des I-Trägers 25, insbesondere dem ersten Kontakt 20, sind zwei Einlässe 32 zur Zuleitung eines Kühlfluids und ein Auslass 33 zur Ableitung des Kühlfluids angeordnet, um eine Kühlung der Komponenten der Stromquelle 10 zu ermöglichen. Der Querschnitt des Auslasses 33 zur Ableitung des Kühlfluids weist die Summe der Querschnitte aller Einlässe 32 zur Zuleitung des Kühlfluids auf. Für einen optimalen Verlauf des Kühlfluids sind die Kühlkanäle 39 entsprechend angeordnet (siehe Figur 9 und 11). Als Kühlfluid kann Wasser oder eine andere Flüssigkeit, aber auch ein gasförmiges Kühlmittel herangezogen werden.

Wie der Explosionsdarstellung der Stromquelle 10 gemäß Fig. 6 entnommen werden kann, sind die Stromwandler 18 zur Messung der sekundärseitigen Ströme des Hochstromtransformators 12 direkt an den ganz oben angeordneten Sekundärwicklungen 14 platziert, d.h., es ist jeweils an der ersten bzw. obersten Sekundärwicklung 14 beiderseits des I-Trägers 25 ein Stromwandler 18 derart angeordnet, sodass aufgrund des induzierten Stroms der Strom durch diese Sekundärwicklung 14 ermittelt werden kann. Zur Vermeidung einer Beeinflussung der durch die Stromwandler 18 gemessenen Ströme durch Fremdmagnetfelder ist vorzugsweise ein Gehäuse 34 aus magnetisch leitfähigem Material, beispielsweise Ferriten, zur Abschirmung über den Stromwandlern 18 angeordnet.

Die Stromwandler 18 sind beiderseits des I-Trägers 25 auf der jeweils ersten und zweiten Sekundärwicklung 14 angeordnet. Aufgrund des Stromflusses durch die Primärwicklungen 13 tritt der Strom auf einer Seite des I-Trägers 25 aus, wodurch die oberste Sekundärwicklung 14 somit die erste Sekundärwicklung 14 ausbildet, wogegen auf der gegenüberliegenden Seite nunmehr der Strom in die oberste Sekundärwicklung 14 eintritt und somit die zweite Sekundärwicklung ausbildet. Durch den Einsatz einer Vollbrücke ist es erforderlich, dass der Stromfluss immer von der ersten und zweiten Sekundärwicklung 14 unabhängig voneinander erfasst wird, sodass je nach Abhängigkeit des Stroms die korrespondierenden Schaltelemente 24 des Synchronwandlers 16 angesteuert werden können. Damit ist es möglich, dass die Schaltelemente 24 der beiden Seiten des I-Trägers 25 nahezu synchron von einem vom Stromwandler 18 hervorgerufenen Ansteuersignal angesteuert werden.

Zwischen den Kontaktplatten 29 und dem I-Träger 25 sind die Platinen 35 des Synchrongleichrichters 16 und der Ansteuerschaltung 17 angeordnet. Die Platinen 35 bilden gleichzeitig die notwendige Isolation zwischen dem I-Träger und den Kontaktplatten 29. Die entsprechenden Schaltelemente 24 des Synchrongleichrichters 16 werden direkt mit den Sekundärwicklungen 14 des Hochstromtransformators 12 kontaktiert. Über entsprechende Ausbuchtungen 36, insbesondere zinnenförmige Ausbuchtungen, an der Innenfläche der Kontaktplatte 29 und entsprechende Öffnungen 37 an der Platine 35 unterhalb der Schaltelemente 24 kann eine direkte Kontaktierung der Schaltelemente 24 mit der Kontaktplatten 29 erfolgen. Die Schaltelemente 24 sind vorzugsweise durch geeignete Feldeffekttransistoren gebildet, deren Drain-Anschlüsse durch deren Gehäuse gebildet sind. Die Gehäuse der Feldeffekttransistoren werden direkt bzw. leitungslos mit der zumindest einen Sekundärwicklung 14 des Hochstromtransformators 12 verbunden, sodass keine Leitungen zwischen diesen Einheiten erforderlich sind. Beispielsweise werden Feldeffekttransistoren aus Silizium oder Galliumnitrid eingesetzt. Die Stromwandler 18 werden direkt mit der daneben angeordneten Platine 35 des Synchrongleichrichters 16 und der Ansteuerschaltung 17 und über eine geeignete Leitung 38 mit der gegenüberliegenden Platine 35 des Synchrongleichrichters 16 und der Ansteuerschaltung 17 verbunden.

Der Zusammenbau der Stromquelle 10 gemäß den Fig. 5 und 6 erfolgt vorzugsweise mit einem Lötverfahren unter Verwendung zweier verschiedener Löttemperaturen. Zuerst werden die Sekundärwicklungen 14 mit den Ausnehmungen 25a des I-Trägers 25 unter Verwendung eines Lötmaterials, insbesondere eines Lötzinns, welches bei einer ersten, höheren Temperatur T_{S1}, beispielsweise 260°C, schmilzt, verbunden. Auch die Kontaktplatten 29 werden unter Verwendung eines Lötmaterials, welches bei der ersten, höheren Schmelztemperatur T_{S1}, beispielsweise 260°C schmilzt, mit den Platinen 35 kontaktiert. Danach werden wiederum unter Verwendung eines Lötmaterials, welches bei der ersten Schmelztemperatur T_{S1}, beispielsweise 260°C, schmilzt, die Bauteile des Synchrongleichrichters 16 und der Ansteuerschaltung 17 auf der Platine 35 montiert. Durch die Kapillarwirkung der Platine 35 auf der Kontaktplatte 29 ist keine Gefahr einer Lösung der Platine 35 von der Kontaktplatte 29 gegeben. Nach diesen Arbeitsschritten werden die außenseitigen Kontakte der Sekundärwicklungen 14 und die Kontakte an den Platinen 35 mit Lötmaterial mit einer zweiten, gegenüber der ersten Schmelztemperatur T_{S1} niedrigeren Schmelztemperatur T_{S2}, beispielsweise 180°C, besiebt, die Kontaktplatten 29 mit den Platinen 35 mit dem I-Träger 25 verbunden, vorzugsweise verschraubt, und danach über die zweite Schmelztemperatur T_{S2} des Lötmaterials, beispielsweise 180°C aufgewärmt, sodass die Verbindung der Sekundärwicklungen 14 mit den Schaltelementen 24 der Synchrongleichrichter 16 hergestellt werden. Durch die Verwendung eines Lötmaterials mit dieser zweiten, niedrigeren Schmelztemperatur T_{S2} kann sichergestellt werden, dass die mit dem Lötmaterial mit höherer Schmelztemperatur T_{S1} hergestellten Lötverbindungen nicht aufgeschmolzen werden bzw. durch Kristallisationsvorgänge hochohmig werden. Schließlich wird die Primärwicklung 13 durch die Ringkerne 15 gefädelt, und anschließend werden die Stromwandler 18 montiert und kontaktiert und die Leitung 38 verlegt. Durch Befestigung der Deckplatten 31 wird die Stromquelle 10 fertiggestellt. Zur Verringerung von Zug- und Biegekräften auf die Komponenten der Stromquelle 10 können sämtliche Hohlräume vor der Montage der Deckplatten 31 vergossen werden. Über dafür vorgesehene Öffnungen (nicht dargestellt) beispielsweise in den Deckplatten 31 kann ein Vergießen auch nach der Montage der Deckplatten 31 erfolgen.

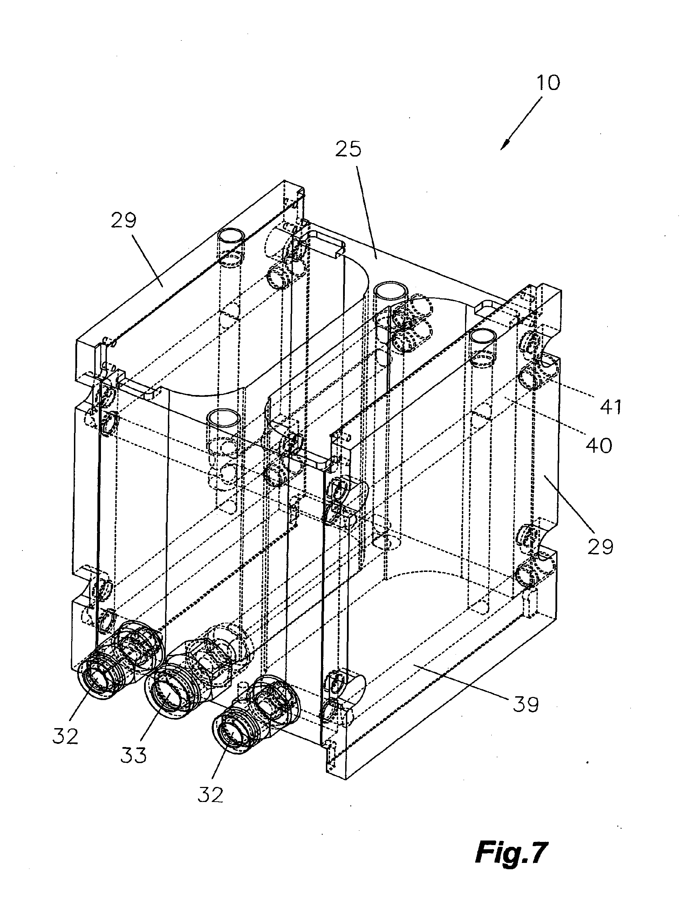

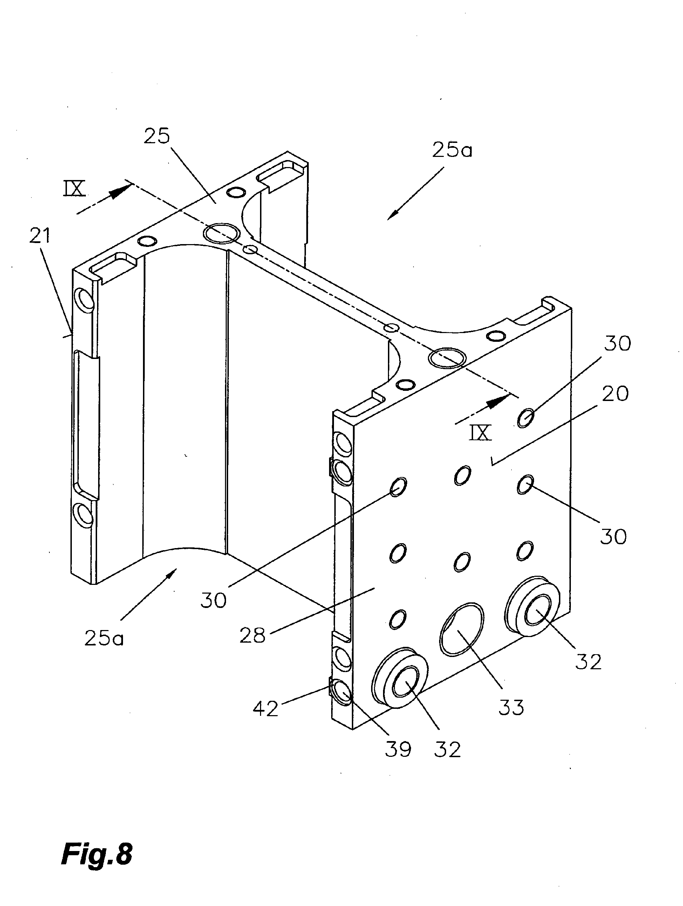

Fig. 7 zeigt die Stromquelle 10 gemäß den Fig. 5 und 6 mit angedeutetem Verlauf der Kühlkanäle 39 (strichliert gezeichnet). Dementsprechend verlaufen die Kühlkanäle 39 von den beiden symmetrisch angeordneten Einlässen 32 zuerst in die Kontaktplatten 29, wo die stärksten Wärmequellen (die Schaltelemente 24 des Synchrongleichrichters 16 und die Bauelemente der Ansteuerschaltung 17) und die empfindlichsten Bauelemente mit dem kühlen Kühlfluid gekühlt werden. Danach verlaufen die Kühlkanäle 39 in die Außenelemente des I-Trägers 25 und in den Mittelsteg des I-Trägers 25, wo die Wicklungen des Hochstromtransformators 12 gekühlt werden, wobei sich die beiden seitlich einströmende Kühlkanäle 39 im Mittelsteg zu einem einzigen Kühlkanal 39 sammeln. Danach münden die Kühlkanäle 39 im gemeinsamen Auslass 33 für das Kühlfluid. Die Kühlkanäle in den Kontaktplatten 29 und im I-Träger 25 werden vorzugsweise durch entsprechende Bohrungen 40 hergestellt die an den entsprechenden Stellen durch Abschlusselemente 41 abgeschlossen werden. Zwischen dem I-Träger 25 und den Kontaktplatten 29 werden zur Abdichtung der Kühlkanäle 39 entsprechende Abdichtelemente 42, beispielsweise O-Ringe, angeordnet (siehe Fig. 8).

In Fig. 8 ist der I-Träger 25 des Hochstromtransformators 12 isoliert von den anderen Komponenten des Hochstromtransformators 12 bzw. der Stromquelle 10 dargestellt. An den Mündungsstellen der Kühlkanäle 39 sind die oben erwähnten Abdichtelemente 42, beispielsweise in Form von O-Ringen, angeordnet. Die Ausnehmungen 25a im I-Träger 25 sind exakt zur Aufnahme des Ringkerns 15 ausgebildet, wodurch ein sehr kompakter Aufbau erzielt wird. Gleichzeitig bildet der Mittelsteg des I-Trägers 25 die Kontaktfläche für die Mittelanzapfung der Sekundärwicklungen 14 des Hochstromtransformators 12 aus. Die Mittelanzapfungen der Sekundärwicklungen 14 werden leitungslose mit dem Mittelsteg des I-Trägers 25 verbunden, wodurch wiederum entsprechende Leitungen entfallen können. Durch die direkte Anbindung der Sekundärwicklungen 14 an den I-Träger 25 wird auch eine wesentliche Vergrößerung der Anschlussfläche erzielt und es können somit wieder Übergangsverluste und Leitungsverluste vermieden werden.

Der I-Träger 25 bildet die Basis des Hochstromtransformators 12, um welche die Sekundärwicklungen 14 derartig angeordnet sind, dass keine Verbindungsleitungen erforderlich sind. Die Außenflächen des I-Trägers 25 stellen die zwei ersten Kontakte 20, 21 der Stromquelle 10 dar, welche direkt, also leitungslos, mit den Zangenarmen 5 der Widerstandsschweißvorrichtung 1 verbunden werden. Eine Platz sparende Anordnung wird dadurch erreicht, dass die Ringkerne 15 nicht kreisförmig, sondern oval bzw. flach ausgeführt sind. Bevorzugt werden geschlossene Ringkerne 15 eingesetzt. Durch diese Ausbildung kann die Serien-/Parallelschaltung der Primärwicklungen 13 und Sekundärwicklungen 14 realisiert werden, durch die das erforderliche Übersetzungsverhältnis des Hochstromtransformators 12 für den hohen bereitszustellenden Gleichstrom bei reduzierten Windungszahlen der Primärwicklungen 13 und Sekundärwicklungen 14 erzielt wird. Ein derartiger Aufbau zahlt sich insbesondere dann aus, wenn auf jeder Seite des I-Trägers 25 zumindest drei parallel geschaltete Sekundärwicklungen 14 angeordnet werden.

Fig. 9 zeigt das Schnittbild durch den I-Träger 25 aus Fig. 8 entlang der Schnittlinie IX-IX. Daraus ist der Verlauf der Kühlkanäle 39 zum gemeinsamen Auslass 33 für das Kühlfluid deutlich ersichtlich.

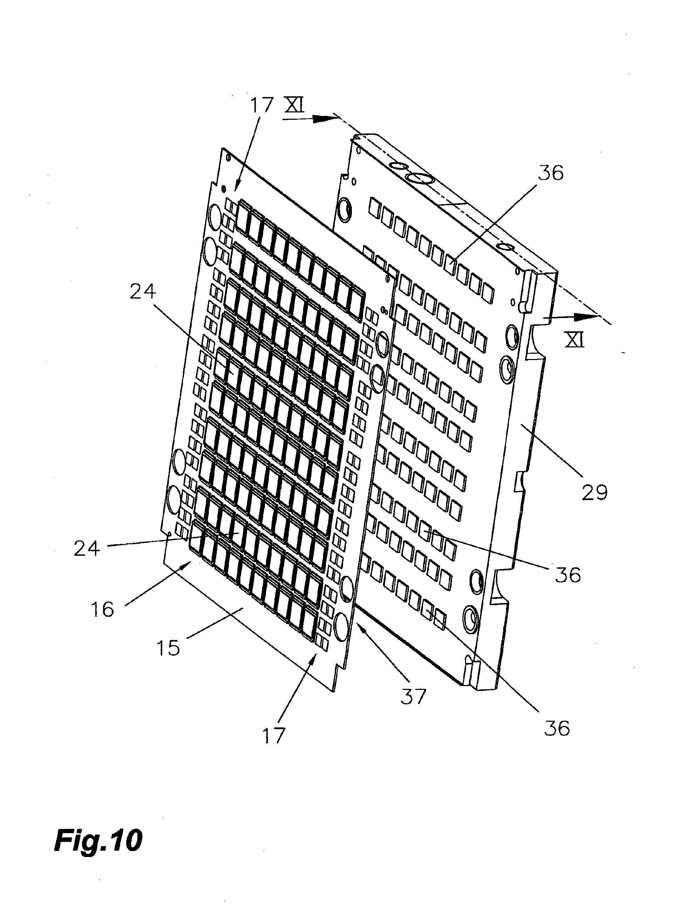

Fig. 10 zeigt eine Kontaktplatte 29 des Hochstromtransformators 12 bzw. der Stromquelle 10 sowie die darüber angeordnete Platine 35 für den Synchrongleichrichter 16 und die Ansteuerschaltung 17 in vergrößerter Darstellung. Wie bereits oben erwähnt, werden die Schaltelemente 24 des Synchrongleichrichters 16 auf der einen Seite direkt mit den entsprechenden Sekundärwicklungen 14 des Hochstromtransformators 12 kontaktiert und an der anderen Seite direkt mit der Kontaktplatte 29 verbunden. Zu diesem Zweck sind an der Innenfläche der Kontaktplatte 29 Ausbuchtungen 36, insbesondere zinnenförmige Ausbuchtungen, angeordnet, die in entsprechende Öffnungen 37 an der Platine 35 ragen und dort die Source-Anschlüsse der über den Öffnungen 37 angeordneten Schaltelemente 24 direkt, bzw. leitungslos, kontaktieren. Durch die Ausbuchtungen 36 kann auf Verbindungsleitungen zwischen den Schaltelementen 24 des Synchrongleichrichters 16 und den Kontaktplatten 29 verzichtet werden, wodurch einerseits die Ohm'-schen Verluste reduziert werden können und andererseits der thermische Übergang zwischen den Schaltelementen 24 und den Kontaktplatten 29 verbessert werden kann. Schließlich wird auch der Herstellungsaufwand verringert, da keine Verbindungsleitungen verlegt und angeschlossen werden müssen, sondern die Schaltelemente 24 direkt mit den Ausbuchtungen 36 verbunden, vorzugsweise verlötet werden. Auch kann damit eine einfache Positionierung der Platine 35 ermöglicht und somit die Herstellung wesentlich vereinfacht werden.

Durch die Anordnung der Ansteuerschaltung 17 und des Synchrongleichrichters 16 auf der Platine 35, die innenseitig der Kontaktplatte 29 angeordnet wird, kann die direkte bzw. leitungslose Kontaktierung der Anschlüsse der Sekundärwicklungen 14 mit den Schaltelementen 24 des Synchrongleichrichters 16 und auch eine direkte bzw. leitungslose Kontaktierung der Ausgänge des Synchrongleichrichters 16 mit der Kontaktplatte 29 erreicht werden. Vorzugsweise ist der Hochstromtransformator 12 bzw. die Stromquelle 10 zur Bereitstellung des Gleichstroms symmetrisch aufgebaut, wobei beiderseits der symmetrisch angeordneten Sekundärwicklungen 14 jeweils eine Platine 35 mit einem Teil des Synchrongleichrichters 16 und der Ansteuerschaltung 17 unterhalb jeweils einer Kontaktplatte 29 angeordnet ist.

Beim Synchrongleichrichter 16 gemäß Fig. 10 sind jeweils zehn Schaltelemente 24 in einer Reihe angeordnet. Um sicherzustellen, dass alle parallel geschalteten Schaltelemente 24 im Wesentlichen gleichzeitig angesteuert werden und sich Laufzeitverluste nur wenig auswirken, erfolgt eine symmetrische Ansteuerung der Schaltelemente 25 von beiden Seiten, d.h., über beidseitig angeordnete Gate-Treiber werden jeweils vorzugsweise fünf Schaltelemente 24 von rechts und links angesteuert. Es können auch andere Ansteuervarianten, wie beispielsweise ein zusätzlich zentral verlaufender Gate-Treiber angeordnet werden, wodurch die Leitungslängen und deren Induktivitäten gedrittelt werden. Durch eine derartige parallele Ansteuerung der Gates der Schaltelemente 24 des Synchrongleichrichters 16 werden kurze Ansteuerwege und somit annähernd synchrone Schaltzeiten der Schaltelemente 24 sichergestellt, da keine bzw. kaum Laufzeitverluste auftreten.

Bei der Montage der Platine 35 auf der Kontaktplatte 29 ragen die Ausbuchtungen 36 der Kontaktplatte 29 durch die Öffnungen 37 in der Platine 35 hindurch, wodurch gleichzeitig die Rückseite der Platine 35 mit der Kontaktplatte 29 sicher verbunden bzw. verlötet werden kann und zusätzlich auf der gegenüberliegenden Seite angeordnete Schaltelemente 24 ebenfalls mit der Kontaktplatte 29 verbunden bzw. verlötet werden können. Damit kann der übliche hohe Verdrahtungsaufwand entfallen. Auch ist damit eine leichte Positionierung der Platine 35 auf der Kontaktplatte 29 möglich und kann diese beim Verlöten nicht mehr verrutschen. Wenn auf der Platine 35 der Synchrongleichrichter 16, die Ansteuerschaltung 17 und die Versorgungsschaltung 48 angeordnet sind, kann ein autarker Aufbau bei der Integration der Platine 35 im Hochstromtransformator 12 erreicht werden. Von Vorteil ist weiters, wenn die Ansteuerschaltung 17 auf beiden Seiten der parallel und in Reihe angeordneten Schaltelemente 24 angeordnet ist, da dadurch eine Verkürzung der Leitungswege zu den einzelnen Schaltelementen 24 erzielt wird. Somit kann sichergestellt werden, dass innerhalb einer sehr kurzen Zeitspanne sämtliche parallel geschalteten Schaltelemente 24 eingeschaltet sind. Durch die beidseitige Anordnung der Ansteuerschaltung 17 wird eine Halbierung der Leitungslänge und damit einhergehend eine Reduktion der Leitungsinduktivitäten und somit eine wesentliche Verkürzung der Schaltzeiten 24 erzielt. Auf einer Seite der Platine 35 ist vorzugsweise vollflächig eine lötbare Oberfläche zum Verlöten mit der Kontaktplatte 29 vorgesehen, wodurch eine sichere Verbindung mit der Kontaktplatte 29 erzielt werden kann. Somit können auch die Übergangswiderstände wesentlich verringert werden, da eine vollflächige Anbindung der Platine 35 einen geringeren Übergangswiderstand aufweist. Anstelle des bevorzugten direkten Verbindens durch Löten können auch kurze Verbindungsdrähte, sogenannte Bonddrähte, vorgesehen werden.

Die Versorgungsschaltung 48 ist vorzugsweise zur Bildung entsprechend hoher Schaltströme, beispielsweise zwischen 800A und 1500A, insbesondere 1000A, und zur Versorgung der Komponenten mit entsprechender Versorgungsspannung ausgebildet. Aufgrund des sehr hohen Schaltstroms kann eine sehr geringe Schaltzeit, insbesondere im ns-Bereich, erzielt werden. Damit kann sichergestellt werden, dass immer zum Nulldurchgang oder unmittelbar kurz vor dem Nulldurchgang bei geringem Ausgangstrom, die Schaltelemente 24 geschaltet werden, sodass keine bzw. kaum Schaltverluste auftreten. Wenn eine Datenkommunikationsschaltung zur drahtlosen Übertragung von Daten, vorzugsweise induktiv, magnetisch oder per Bluetooth, vorgesehen ist, können Daten drahtlos von und an die Platine 35 übertragen werden (nicht dargestellt). Damit kann eine Anpassung der Schaltzeitpunkte zu unterschiedlichen Einsatzgebieten des Hochstromtransformators 12 vorgenommen werden. Ebenso können aus einem an der Platine 35 angeordneten Speicher (nicht dargestellt) Daten für die Weiterverarbeitung oder Kontrolle bzw. für eine Qualitätsüberwachung ausgelesen werden.

Zur Schaffung eines Schutzes der Schaltelemente 24 des Synchrongleichrichters 16 vor Überspannungen ist es von Vorteil, die

Schaltelemente 24 einzuschalten, wenn sie nicht benötigt werden. Im Falle der Anwendung in einer Widerstandsschweißvorrichtung 1 wird also in den Schweißpausen der aktive Synchrongleichrichter 16 aktiviert, um eine Zerstörung der Schaltelemente 24 zu vermeiden. Es wird überwacht, ob ein Primärstrom bzw. Sekundärstrom durch den Hochstromtransformator 12 fließt, und im Falle keines Stromflusses, während die Schweißzange 4 für einen neuen Schweißpunkt entsprechend positioniert wird, aktiviert die Ansteuerschaltung 17 sämtliche Schaltelemente 24 durch entsprechende Ansteuerung der Gates. Wird nach Positionierung der Schweißzange 4 die Stromquelle 10 aktiviert, also ein manueller oder automatischer Schweißvorgang gestartet, so wird an die Primärwicklung 13 des Hochstromtransformators 12 eine Wechselspannung angelegt, die wiederum von der Ansteuerschaltung 17 aufgrund eines Stromflusses erkannt wird, und somit der Schutzmodus der Schaltelemente 24 deaktiviert wird. Selbstverständlich kann die Aktivierung und Deaktivierung der Schaltelemente 24 des Synchrongleichrichters 16 auch über Steuersignale, die per Funk oder induktiv bzw. magnetisch an die Ansteuerschaltung 17 gesendet werden, erfolgen. An den eingeschalteten Schaltelementen 24 können allfällige Überspannungen keinen Schaden anrichten. Auch ein gewisser Minimalschutz der Schaltelemente 24 mit Hilfe von Zenerdioden kann vorgesehen werden.

Fig. 11 zeigt ein Schnittbild durch die Kontaktplatte 29 gemäß Fig. 10 entlang der Schnittlinie XI-XI. Daraus ist der Verlauf der Kühlkanäle 39 deutlich ersichtlich. Die herstellungsbedingten Öffnungen in den Bohrungen 40 zur Bildung der Kühlkanäle 39 werden durch entsprechende Abschlusselemente 41 abgedichtet. Die Abschlusselemente 41 können durch entsprechende Schrauben die in entsprechende Gewinde in den Bohrungen 40 eingedreht werden, realisiert sein.

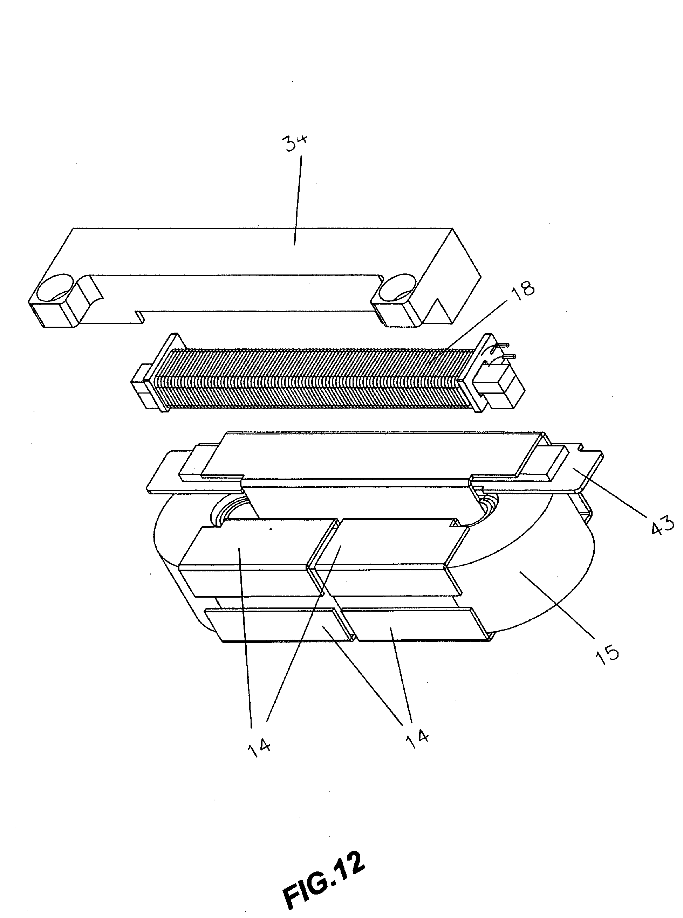

Fig. 12 zeigt einen Ringkern 15 mit zwei darauf angeordneten Sekundärwicklungen 14 des Hochstromtransformators 12 samt darüber angeordnetem Stromwandler 18, der in einer Explosionsdarstellung dargestellt wurde. Der Stromwandler 18 wird mit dem abschirmenden Gehäuse 34 und einer Abschirmung 43 vor fremden Magnetfeldern geschützt, so dass der sekundärseitige Strom durch die Sekundärwicklung 14 möglichst genau gemessen werden kann und der Ansteuerschaltung 17 zur Steuerung der Schaltelemente 24 des Synchrongleichrichters 16 zugeführt werden kann. Zur Abschirmung von Magnetfeldern eignen sich Ferrite als Materialien besonders. Der Stromwandler 18 wird dabei über einen Teilbereich einer der beiden angeordneten Sekundärwicklungen 14 positioniert bzw. befestigt. Wie aus dem Stand der Technik bekannt, wird der Stromwandler 18 aus einem magnetischen Kern mit darüber angeordneter Wicklung gebildet, wobei die Anschlüsse der Wicklung mit der Ansteuerschaltung 17 verbunden werden. Weiters ist zwischen dem Ringkern 15 und der Sekundärwicklung 14 die Abschirmung 43 und ein Kernblech für den Stromwandler 18 angeordnet, wobei der Kern des Stromwandlers 18 auf dieses Kernblech aufgesetzt wird.

Bei diesem Aufbau des Hochstromstransformators 12 sind zwei derartig aufgebaute Sekundärwicklungen 14 beiderseits des I-Trägers 25 angeordnet, sodass die Ansteuerschaltung 17 den Stromfluss durch einen der an beiden Seiten parallel geschalteten und positionierten Sekundärwicklungen 14 misst. Wenn die Ansteuerschaltung 17 mit diesen Stromwandlern 18 verbunden ist, wird eine exakte Steuerung bzw. Regelung möglich, da über die Stromwandler 18 die Zustände im Hochstromtransformators 12 erfasst werden können.

Aufgrund der oben beschriebenen Parallelschaltung der Sekundärwicklungen 14 fließt in jeder Sekundärwicklung 14 der gleiche Strom. Somit muss der Strom nur einer Sekundärwicklung 14 abgriffen werden, um auf den gesamten Stromfluss rückschliessen zu können. Bei einer Parallelschaltung von zehn Sekundärwicklungen 14 wird nur ein Zehntel des gesamten Stromflusses von den Stromwandlern 18 gemessen, weshalb diese wesentlich kleiner dimensioniert werden können. Damit wird wiederum eine Reduktion der Baugröße des Hochstromtransformators 12 bzw. der Stromquelle 10 erzielt. Von Vorteil ist es, wenn die Stromwandler 18 im Wesentlichen 90° zur Richtung des Gleichstroms, insbesondere Schweißstroms, orientiert angeordnet sind, da dadurch Störungen durch das durch den Gleichstrom hervorgerufene Magnetfeld und somit Messfehler reduziert werden können. Somit kann eine sehr genaue Messung durchgeführt werden.

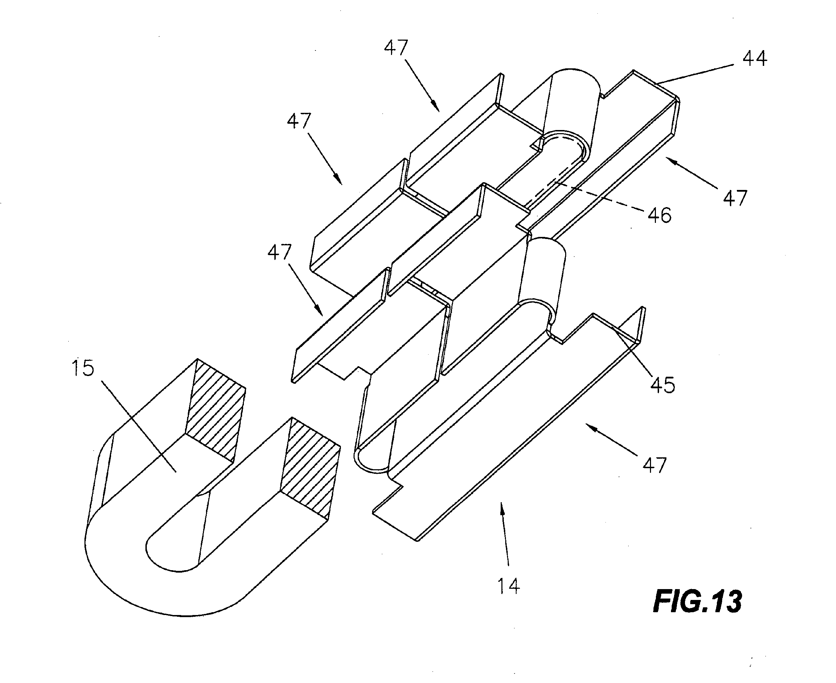

Wie der Explosionsdarstellung gemäß Fig. 13 entnommen werden kann, sind die Sekundärwicklungen 14 des Hochstromtransförmators 12 vorzugsweise durch zwei durch eine Isolierschicht 46, beispielsweise eine Papierschicht, voneinander isolierte Bleche 44, 45 mit im Wesentlichen S-förmigem gegengleichen Verlauf um den Querschnitt eines Ringkerns 15 und durch den Ringkern 15 gebildet, welche ineinander angeordnet werden. An einem Ringkern 15 sind also zwei Sekundärwicklungen 14 bzw. die Teile der Sekundärwicklung 14 mit Mittelanzapfung angeordnet. Die außenliegenden Flächen 47 der Bleche 44, 45 der Sekundärwicklungen 14 bilden gleichzeitig die Kontaktflächen für die Kontaktierung mit den Schaltelementen 24 des Synchrongleichrichters 16 und dem I-Träger 25, der als Mittelpunkt der Gleichrichtung fungiert. Somit sind keine Leitungen zur Verbindung der Sekundärwicklungen 14 des Hochstromtransformators 12 mit den Schaltelementen 24 des Synchrongleichrichters 16 erforderlich. Die Sekundärwicklungen 14, insbesondere die die Sekundärwicklungen 14 ausbildenden Bleche 44, 45 werden direkt bzw. leitungslos mit den Schaltelementen 24 des Synchrongleichrichters 16 und mit dem Mittelsteg des I-Trägers 25 bzw. dem Mittelpunkt der Gleichrichtung verbunden. Damit wird ein sehr Platz sparender und kompakter Aufbau mit geringem Gewicht und geringen Verlusten erzielt. Gleichzeitig stehen für die Verbindung der Sekundärwicklung 14 mit dem Mittelsteg des I-Trägers 25 und den Schaltelementen 24 des Synchrongleichrichters 16 relativ große Flächen 47 für eine Kontaktierung zur Verfügung, um mit möglichst wenig Verlusten den hohen Stromfluss zu gewährleisten. Durch diese Anordnung wird sekundärseitig ein Mittelpunktgleichrichter realisiert, wobei der I-Träger 25 mit dem verbundenen einen Ende der Sekundärwicklungen 14 den Mittelpunkt bilden.

Der Ringkern 15 kann aus Ferriten, amorphen Materialien oder nanokristallinen Werkstoffen gebildet werden. Je besser die verwendeten Materialien hinsichtlich der magnetischen Eigenschaften sind, desto kleiner kann der Ringkern 15 ausgeführt werden. Allerdings steigt dadurch natürlich auch der Preis für den Ringkern 15. Wesentlich ist bei der Ausbildung der Bleche 44, 45, dass diese derart gefaltet bzw. gebogen werden, dass sie zumindest einmal durch den Ringkern 15 geführt werden. Die beiden auf einem Ringkern 15 angeordneten Bleche 44, 45 bzw. Sekundärwicklungen 14 werden gegengleich ausgebildet und voneinander isoliert.

Fig. 14 zeigt ein Blockschaltbild einer Versorgungsschaltung 48, insbesondere eines Netzteils, zur Versorgung des Synchrongleichrichters 16 und der Ansteuerschaltung 17 mit elektrischer Energie. Die Versorgungsschaltung 48 wird mit der Sekundärseite bzw. den Anschlüssen der Sekundärwicklung 14 des Hochstromtransformators 12 verbunden und beinhaltet einen Spitzenwertgleichrichter 49, einen Spannungshochsetzer 50, einen Längsregler 51 und einen Spannungsteiler 52. Der Spannungshochsetzer 50 bzw. Booster stellt sicher, dass die Versorgung der Komponenten der Stromquelle 10 möglichst rasch zur Verfügung steht. Gleichzeitig wird so schnell als möglich, die interne Versorgungsspannung des aktiven Synchrongleichrichters 16 generiert. Durch die Verwendung des Spannungshochsetzers 50 wird in der Anfangsphase der Aktivierung sichergestellt, dass zu einem möglichst frühen Zeitpunkt die benötigte Amplitude der Versorgungsspannung zuerst erzeugt wird, um eine sichere Funktion des in den Hochstromtransformator 12 integrierten Synchrongleichrichters 16 zu einem möglichst frühen Zeitpunkt zu gewährleisten.

Fig. 15 zeigt den Zeitverlauf der Versorgungsspannung V der Versorgungsschaltung 48 gemäß Fig. 14. Die Rampe des Spannungsanstiegs ΔV/Δt wird ausreichend steil gewählt, sodass sichergestellt wird, dass die erforderliche Spannung VCC mit einer maximalen zeitlichen Verzögerung T_{d} am Synchrongleichrichter 16 und der Ansteuerschaltung 17 anliegt. Beispielsweise sollte die zeitliche Verzögerung T_{d} < 200µs betragen. Durch entsprechende Auslegung der Schaltungen des Spitzenwertgleichrichters 49 und Spannungshochsetzers 50 und entsprechend niedrige Kapazitäten kann eine ausreichende Anstiegsgeschwindigkeit der Spannung erzielt werden. Man kann also sagen, dass zuerst die minimale Höhe der Vorsorgungsspannung mit einem steilen Anstieg sichergestellt wird und anschließend erst die richtige Versorgung aufgebaut wird.

Fig. 16 zeigt Zeitverläufe des sekundärseitigen Stroms I_{S} des Hochstromtransformators 12 und der Steuersignale G₁ und G₂ für die Schaltelemente 24 des Synchrongleichrichters 16 zur Veranschaulichung der verlustfreien Ansteuerung. Über die Messung der sekundärseitigen Ströme I_{S} einer Sekundärwicklung 14 mit Hilfe entsprechender Stromwandler 18 erhält die Ansteuerschaltung 17 die Information, wann die Schaltelemente 24 des Synchrongleichrichters 16 geschaltet werden sollen. Zur Verringerung der Durchlassverluste und Schaltverluste werden die Schaltelemente 24 des Synchrongleichrichters 16 möglichst im Nulldurchgang der sekundärseitigen Ströme durch die Sekundärwicklungen 14 des Hochstromtransformators 12 geschaltet. Da es von der Erfassung des Nulldurchgangs des sekundärseitigen Stroms I_{S} durch die Stromwandler 18 bis zur Aktivierung der Schaltelemente 24 des Synchrongleichrichters 16 zu gewissen Verzögerungen t_{Pre} kommt, ist die Ansteuerschaltung 17 erfindungsgemäß dazu ausgebildet, die Schaltelemente 24 des Synchrongleichrichters 16 zu einem voreingestellten Zeitpunkt vor dem Erreichen des Nulldurchgangs des Stroms in der Sekundärwicklung 14 anzusteuern. Die Ansteuerschaltung 17 bewirkt also die Schaltung der Schaltelemente 24 des Synchrongleichrichters 16 zu Zeitpunkten, zu welchen die durch die Stromwandler 18 gemessenen Ströme I_{S} in der Sekundärwicklung 14 des Hochstromtransformators 12 eine bestimmte Einschaltschwelle I_{SE} und Ausschaltschwelle I_{SA} unterschreiten bzw. überschreiten. Durch diese Maßnahme kann erreicht werden, dass die Schaltelemente 24 des Synchrongleichrichters 16 im Wesentlichen während des Nulldurchgangs der Ströme I_{S} durch die Sekundärwicklung 14 des Hochstromtransformators 12 geschaltet werden, wodurch die Durchlassverluste und Schaltverluste der Schaltelemente 24 des Synchrongleichrichters 16 minimiert werden können. Der Ein- und Ausschaltzeitpunkt der Schaltelemente 24 des Synchrongleichrichters 16 wird also nicht mit dem Nulldurchgang des sekundärseitigen Stroms sondern mit Erreichen der definierten Einschaltschwelle I_{SE} und Ausschaltschwelle I_{SA} festgelegt. Die Einschaltschwelle I_{SE} und Ausschaltschwelle I_{SA} wird entsprechend den zu erwartenden Schaltverzögerungen definiert. Allenfalls können die Einschaltschwelle I_{SE} und Ausschaltschwelle I_{SA} verstellbar ausgebildet sein, um die Verluste noch mehr reduzieren zu können. Bei einem 20kA Hochstromtransformator 12 kann beispielsweise der Schaltzeitpunkt 100ns vor dem Nulldurchgang festgelegt werden, sodass die Schaltelemente 24 des Synchrongleichrichters 16 innerhalb dieser Zeitdauer geschaltet werden müssen.

Ein üblicher Hochstromtransformator des Standes der Technik für eine Widerstandsschweißvorrichtung für die Bereitstellung eines Schweißstroms von beispielsweise 20kA weist etwa 40-50 kW Verluste auf. Insgesamt wird für die Bereitstellung eines Schweißstroms von 20kA nach dem Stand der Technik eine Anschlussleistung von bis zu 150kW benötigt, wobei die gesamten Verluste etwa 135kW betragen, resultierend in einem Wirkungsgrad von etwa 10%. Dagegen zeigt ein Hochstromtransformator 12 der gegenständlichen Art nur etwa 5-6kW Verluste. Die Leitungsverluste können von üblicherweise 30kW auf 20kW gesenkt werden. Somit kann bei einer erfindungsgemäßen Widerstandsschweißvorrichtung 1 für die Erzeugung eines Schweißstroms von 20kA die Anschlussleistung auf 75kW reduziert werden, da die gesamten Verluste nur mehr etwa 60kW betragen. Der resultierende Wirkungsgrad ist demnach mit etwa 20% etwa doppelt so hoch, wie beim Stand der Technik. Dieser Vergleich zeigt sehr deutlich das mögliche Einsparungspotenzial, insbesondere bei Fertigungsstraßen in der Automobilindustrie mit einer Vielzahl an Widerstandsschweißvorrichtungen.

Grundsätzlich ist die beschriebene Stromquelle 10 bzw. der Hochstromtransformator 12 in Form eines Würfel bzw. Quaders ausgebildet, wobei zwei Seitenflächen durch einen I-Träger 25 gebildet sind, an welchen Seitenflächen elektrisch isolierte Kontaktplatten 29 zur Bildung der dritten und vierten Seitenfläche angeordnet sind. Stirnseitig wird zu den vier Seitenflächen jeweils eine Deckplatte 31, die gegenüber dem I-Träger 25 elektrisch isoliert ist, zur Bildung der fünften und sechsten Seitenfläche des Würfels bzw. Quaders angeordnet. Innerhalb des Würfels, insbesondere den Seitenflächen, ist der Synchrongleichrichter 16 und die Ansteuerschaltung 17 auf zumindest einer Platine 35 bzw. Leiterplatte angeordnet. Der Würfel weist somit lediglich Anschlüsse 26 für die Primärwicklungen 13 des Hochstromtransformators 12 und die Seitenflächen als Kontaktflächen zur Abnahme des Gleichstroms bzw. der Gleichspannung auf. Zusätzlich sind noch Kühlanschlüsse, insbesondere die Einlässe 32 und der Auslass 33 für ein Kühlfluid vorgesehen. Steuerleitungen für den im Würfel integrierten Synchrongleichrichter 16 und die Ansteuerschaltung 17 sind vorzugsweise nicht vorgesehen, da dieses System autark arbeitet und somit keine Verbindungen zum Leistungsteil 19 bzw. zu einer Steuervorrichtung der Anlage notwendig sind. Bei einem derartigen Aufbau werden vorzugsweise keinerlei Steuerleitungen benötigt, sondern die Stromquelle 10 nur noch primärseitig mit einem Leistungsteil 19 verbunden, worauf an der Sekundärseite der entsprechend dimensionierte Gleichstrom von beispielsweise 15kA bis 40kA zur Verfügung steht. Der Benutzer braucht somit keinerlei Einstellungen vornehmen, sondern lediglich die Stromquelle 10 anzuschließen. Die Vereinigung der eigentlich unabhängigen eigenständigen Komponenten zu einer derartigen gemeinsamen Einheit bewirkt, dass die Baugröße und somit das Gewicht der Stromquelle 10 wesentlich reduziert werden kann. Gleichzeitig kann die Einheit auch als tragendes Element direkt in einer Anwendung, insbesondere einer Schweißzange 4, eingesetzt werden. Auch wird die Bedienerfreundlichkeit wesentlich erhöht.

Wesentlich bei dem erfindungsgemäßen Aufbau ist weiters, dass die Schaltelemente 24 leitungslos mit den entsprechenden Komponenten verbunden werden, d.h. dass die den Schweißstrom leitenden Source-Anschlüsse der durch Feldeffekttransistoren gebildeten Schaltelemente 24 direkt mit den Ausbuchtungen 36 der Kontaktplatte 29 verbunden bzw. verlötet sind, wobei ebenfalls die Gate-Anschlüsse der Schaltelemente 24 direkt auf der Platine 35 und der darauf aufgebauten Ansteuerschaltung 17 (Gate-Treiber) angeordnet bzw. verlötet sind. Somit können die Induktivitäten von Leitungen durch vollständiges Einsparen der Leitungen reduziert werden, sodass hohe Schaltgeschwindigkeiten und sehr geringe Durchlassverluste erzielt werden können.

Bei dem dargestellten und beschriebenen Ausführungsbeispiel wurde der Hochstromtransformator 12 für einen Strom von 20kA bei einer Ausgangsspannung zwischen 5V und 10V dimensioniert. Dabei weist der I-Träger 25 eine Bauhöhe von 15cm auf, sodass beidseitig jeweils fünf Sekundärwicklungen 14 mit den Ringkernen 15 angeordnet werden können. Um auf ein entsprechendes Übersetzungsverhältnis von 100 zu kommen, sind beim dargestellten Ausführungsbeispiel zehn Primärwicklungen 13 notwendig.

Will man nunmehr den Hochstromtransformator 12 für einen höheren Strom von beispielsweise 30kA dimensionieren, so kann die Anzahl der verwendeten Sekundärwicklungen 14 einfach erhöht werden. Beispielsweise können beidseitig in den Ausnehmungen 25a des I-Trägers 25 jeweils sieben Sekundärwicklungen 14 angeordnet werden, wobei der I-Träger 25 in seiner Höhe entsprechend vergrößert wird, beispielsweise um lediglich 5cm höher ausgeführt wird bzw. ein entsprechend größerer Grundkörper eingesetzt wird. Somit wird der I-Träger 25 des Hochstromtransformators 12 beidseitig lediglich um zwei Sekundärwicklungen 14 ergänzt, um einen höheren Strom bereitstellen zu können. Durch die Vergrößerung werden auch die Kontaktkühlflächen vergrößert. Weiters werden entsprechend mehr Schaltelemente 24 parallel angeordnet. Die Primärwicklung 13 kann auf eine geringere Windungszahl, beispielsweise sieben Windungen reduziert werden, sodass eine Übersetzung von beispielsweise 98 erreicht wird. Höhere primäre Wicklungsverluste werden durch den höheren Primärstrom aufgrund der möglichen Erhöhung des Querschnittes und der Reduktion der Leitungslänge kompensiert.

Eine Erhöhung des sekundären Schweißstromes von 20kA auf 30kA hat somit lediglich eine Verlängerung des Würfels bzw. Hochstromtransformators 12 um beispielsweise 5cm zur Folge.

Da der Hochstromtransformator 12 vorzugsweise autark arbeitet und keine Steuerleitungen aufweist, sollte für allfällige Fehlermeldungen eine Kommunikation nach außen mit externen Komponenten, insbesondere einer Steuervorrichtung, ermöglicht werden. Hierzu kann der Sekundärkreis bestehend aus den Sekundärwicklungen 14 und dem Synchrongleichrichter 16 und der Ansteuerschaltung 17 verwendet werden. Dabei kann bei bestimmten Zuständen, insbesondere im Leerlauf des Hochstromtransformators 12, dieser bewusst mit Hilfe des Synchrongleichrichters 16 kurzgeschlossen werden, sodass von einer externen Überwachungseinheit bzw. einer Steuervorrichtung ein Leerlaufstromfluss in den Primärleitungen erkannt wird und somit aufgrund des Stromes eine Kommunikation bzw. eine Fehlermeldung stattfinden kann.

Beispielsweise kann durch Integration eines Temperaturfühlers im Hochstromtransformator 12, insbesondere am Synchrongleichrichter 16, die Temperatur erfasst und ausgewertet werden. Steigt die Temperatur beispielsweise über einen definierten Schwellwert, so wird von der Ansteuerschaltung 17 der Synchrongleichrichter 16 im Leerlauf, also in den Schweißpausen, definiert kurzgeschlossen. Da die externe Steuervorrichtung den Leerlaufzustand, während desm gerade keine Schweißung durchgeführt wird, kennt, wird diese durch den erhöhten Stromfluss in den Primärleitungen des Hochstromtransformators 12 detektiert bzw. erkannt. Nun kann von der externen Steuervorrichtung überprüft werden, ob der Kühlkreislauf aktiviert ist, oder dieser einen Fehler aufweist bzw. die Kühlleistung erhöht wird, sodass eine bessere Kühlung stattfindet.

Selbstverständlich können über entsprechende Schalt- bzw. Pulsmuster, also definiertes Öffnen und Schließen der Schaltelemente 24 des Synchrongleichrichters 16 im Leerlauf unterschiedliche Fehlermeldung nach außen kommuniziert werden. Beispielsweise können unterschiedliche Temperaturwerte, Sekundärspannungen, Ströme, Fehlermeldungen usw. nach außen gesendet werden.

Es ist aber auch möglich, dass eine derartige Kommunikation während einer Schweißung durchgeführt wird, obgleich eine derartige Detektion deutlich erschwert ist. Dabei können beispielsweise entsprechende Signale auf den primärseitigen Strom, insbesondere durch die Primärwicklungen 13 aufzumodulieren.

## Patentansprüche

1. Widerstandsschweißvorrichtung (1) mit einer Stromquelle (10) zur Bereitstellung eines Schweißstroms zum Verschweißen von Werkstücken (2, 3), mit einer Schweißzange (4) mit zwei Zangenarmen (5) mit jeweils einer Elektrode (7) zum Einprägen des Schweißstroms in die Werkstücke (2, 3), wobei die Stromquelle (10) einen Hochstromtransformator (12) mit zumindest einer Primärwicklung (13) und zumindest einer Sekundärwicklung (14) mit Mittelanzapfung, einen mit der zumindest einen Sekundärwicklung (14) des Hochstromtransformators (12) verbundenen Synchrongleichrichter (16) mit Schaltelementen (24) und eine Schaltung (17) zur Ansteuerung der Schaltelemente (24) des Synchrongleichrichters (16) aufweist, **dadurch gekennzeichnet, dass** die Stromquelle (10) an der Schweißzange (4) angeordnet ist, und die Stromquelle (10) zur Bildung einer Mehrpunktkontaktierung am Ausgang des Synchrongleichrichters (16) zumindest vier Kontakte (20, 21, 22, 23) aufweist, wodurch der Schweißstrom zumindest halbiert und dadurch die Übergangsverluste reduziert werden, wobei zwei erste Kontakte (20, 21) einer Polarität mit dem einen Zangenarm (5) und zwei weitere Kontakte (22, 23) einer entgegengesetzten Polarität mit dem anderen Zangenarm (5) verbunden sind, und wobei an zumindest zwei Kontakten (20, 21, 22, 23) leitungslos der Zangenarm (5) befestigt ist.

2. Widerstandsschweißvorrichtung (1) nach Anspruch 1, **dadurch gekennzeichnet, dass** die zwei ersten Kontakte (20, 21) der einen Polarität und die zwei weiteren Kontakte (22, 23) der entgegengesetzten Polarität jeweils gegenüberliegend angeordnet sind, wobei die zwei weiteren Kontakte (22, 23) gegenüber den zwei ersten Kontakten (20, 21) im Wesentlichen um 90° zueinander versetzt angeordnet sind.

3. Widerstandsschweißvorrichtung (1) nach Anspruch 1 oder 2, **dadurch gekennzeichnet, dass** der Synchrongleichrichter (16) und die Ansteuerschaltung (17) im Hochstromtransformator (12) integriert sind.

4. Widerstandsschweißvorrichtung (1) nach einem der Ansprüche 1 bis 3, **dadurch gekennzeichnet, dass** der Synchrongleichrichter (16) mehrere parallel geschaltete Schalteelemente (24) aufweist und die Schaltelemente (24) des Synchrongleichrichters (16) leitungslos mit der zumindest einen Sekundärwicklung (14) des Hochstromtransformator (12) verbunden sind.

5. Widerstandsschweißvorrichtung (1) nach einem der Ansprüche 1 bis 4, **dadurch gekennzeichnet, dass** der Hochstromtransformator (12) mehrere, vorzugsweise zumindest 10, in Serie geschaltete Primärwicklungen (13) und mehrere, vorzugsweise zumindest 10, parallel geschaltete Sekundärwicklungen (14) mit Mittelanzapfung aufweist.

6. Widerstandsschweißvorrichtung (1) nach einem der Ansprüche 1 bis 5, **dadurch gekennzeichnet, dass** der Hochstromtransformator (12) einen I-Träger (25) aus elektrisch leitfähigem Material aufweist, in dessen Ausnehmungen (25a) jeweils zumindest ein Ringkern (15) angeordnet ist, wobei jeweils ein Anschluss jeder Sekundärwicklung (14) direkt mit einer Innenfläche des I-Trägers (25) kontaktiert ist, und dass die Außenflächen (28) des I-Trägers (25) die zwei ersten Kontakte (20, 21) der Stromquelle (10) bilden, und dass die Mittelanzapfung der zumindest einen Sekundärwicklung (14) des Hochstromtransformators (12) leitungslos mit dem I-Träger (25) verbunden ist.

7. Widerstandsschweißvorrichtung (1) nach Anspruch 6, **dadurch gekennzeichnet, dass** die zumindest eine Primärwicklung (13) des Hochstromtransformators (12) durch den zumindest einen Ringkern (15) verlaufend angeordnet ist.

8. Widerstandsschweißvorrichtung (1) nach Anspruch 6 oder 7, **dadurch gekennzeichnet, dass** über den Ausnehmungen (25a) des I-Trägers (25) jeweils eine Kontaktplatte (29) aus elektrisch leitfähigem Material angeordnet ist, welche über den Synchrongleichrichter (16) und die Ansteuerschaltung (17) mit den jeweiligen anderen Anschlüssen jeder Sekundärwicklung (14) verbunden ist, wobei die Außenflächen der Kontaktplatten (29) die zwei weiteren Kontakte (22, 23) der Stromquelle (10) bilden.

9. Widerstandsschweißvorrichtung (1) nach einem der Ansprüche 1 bis 8, **dadurch gekennzeichnet, dass** jeweils eine Sekundärwicklung (14) mit Mittelanzapfung durch zwei voneinander isolierte Bleche (44, 45) aus elektrisch leitfähigem Material mit im Wesentlichen S-förmigem, gegengleichen Verlauf um den Querschnitt eines Ringkerns (15) und durch den Ringkern (15) gebildet ist, wobei die außenliegenden Flächen (47) der Bleche (44, 45) die Kontakte für die Verbindung mit den Schaltelementen (24) des Synchrongleichrichters (16) bzw. den Elektroden (7) bilden.

10. Widerstandsschweißvorrichtung (1) nach Anspruch 8 oder 9, **dadurch gekennzeichnet, dass** der I-Träger (25) und die Kontaktplatten (29) des Hochstromtransformators (12) eine Würfel- oder Quaderförmige Einheit bilden, wobei zwischen dem I-Träger (25) und den Kontaktplatten (29) eine elektrische Isolierung angeordnet ist, an den Stirnseiten des I-Trägers (25) Deckplatten (31) angeordnet sind, und die Deckplatten (31) aus elektrisch leitfähigem Material gebildet und mit den Kontaktplatten (29) verschraubbar sind, sodass die Kontaktplatten (29) elektrisch verbunden sind.

11. Widerstandsschweißvorrichtung (1) nach einem der Ansprüche 6 bis 10, **dadurch gekennzeichnet, dass** der I-Träger (25) und/oder die Kontaktplatten (29) und/oder die Deckplatten (31) und/oder die Bleche (44, 45) zur Bildung der Sekundärwicklung (14) des Hochstromtransformators (12) aus Kupfer oder einer Kupferlegierung, vorzugsweise mit einer Silberbeschichtung, gebildet ist.

12. Widerstandsschweißvorrichtung (1) nach einem der Ansprüche 6 bis 11, **dadurch gekennzeichnet, dass** der I-Träger (25) und/oder die Kontaktplatten (29) zumindest teilweise durch die Zangenarme (5) gebildet sind.

13. Widerstandsschweißvorrichtung (1) nach einem der Ansprüche 1 bis 12, **dadurch gekennzeichnet, dass** an den Anschlüssen einer Sekundärwicklung (14) jeweils ein Stromwandler (18) zur Messung des Stroms durch diese Sekundärwicklung (14) angeordnet ist, welche Stromwandler (18) mit der Ansteuerschaltung (17) verbunden sind.

14. Widerstandsschweißvorrichtung (1) nach Anspruch 13, **dadurch gekennzeichnet, dass** die Stromwandler (18) im Wesentlichen 90° zur Richtung des Schweißstroms orientiert angeordnet sind.

15. Widerstandsschweißvorrichtung (1) nach Anspruch 13 oder 14, **dadurch gekennzeichnet, dass** die Ansteuerschaltung (17) zur Aktivierung der Schaltelemente (24) des Synchrongleichrichters (16) zu einem voreingestellten Zeitpunkt vor dem Erreichen des Nulldurchgangs des Stroms in der Sekundärwicklung (14) ausgebildet ist.

16. Widerstandsschweißvorrichtung (1) nach einem der Ansprüche 8 bis 15, **dadurch gekennzeichnet, dass** im I-Träger (25) und den Kontaktplatten (29) Kanäle (39) zur Führung eines Kühlfluids angeordnet sind, wobei an einer Außenfläche (28) des I-Trägers (25) zwei Einlässe (32) zur Zuleitung des Kühlfluids und ein Auslass (33) zur Ableitung des Kühlfluids angeordnet sind, wobei die Kühlkanäle (39) von jedem Einlass (32) zu den Kontaktplatten (29) und über den I-Träger (25) zum Auslass (33) verlaufend angeordnet sind.

17. Widerstandsschweißvorrichtung (1) nach einem der Ansprüche 8 bis 16, **dadurch gekennzeichnet, dass** die Ansteuerschaltung (17) und der Synchrongleichrichter (16) auf zumindest einer Platine (35) angeordnet sind, welche Platine (35) an der Innenfläche zumindest einer Kontaktplatte (29) angeordnet ist, und jede Platine (35) des Synchrongleichrichters (16) und der Ansteuerschaltung (17) Öffnungen (37) aufweist, über welchen die Schaltelemente (24) angeordnet sind, und dass die Innenfläche der Kontaktplatten (29) an den Stellen der Öffnungen (37) in der Platine (35) des Synchrongleichrichters (16) Ausbuchtungen (36), insbesondere zinnenförmige Ausbuchtungen, aufweisen, sodass die Schaltelemente (24) über die durch die Öffnungen (37) der Platine (35) ragenden Ausbuchtungen (36) an der Innenfläche der Kontaktplatten (35) leitungslos kontaktierbar sind.

## Claims

1. A resistance welding device (1) comprising a power source (10) in order to provide a welding current for welding workpieces (2, 3), a welding gun (4) with two gun arms (5) comprising one electrode (7) each in order to impress the welding current into the workpieces (2, 3), wherein the power source (10) comprises a heavy-current transformer (12) with at least one primary winding (13) and at least one secondary winding (14) with center tapping, a synchronous rectifier (16) connected with the at least one secondary winding (14) of the heavy-current transformer (12) and comprising switching elements (24), and a circuit (17) for actuating the switching elements (24) of the synchronous rectifier (16), **characterized in that** the power source (10) is arranged at the welding gun (4) and the power source (10) comprises at least four contacts (20, 21, 22, 23) to form a multi-point contacting at the output of the synchronous rectifier (16), whereby the welding current is at least halved and thus the transition losses are reduced, wherein two first contacts (20, 21) of one polarity are connected to the one gun arm (5) and two additional contacts (22, 23) of opposite polarity are connected to the other gun arm (5), and wherein the gun arm (5) is fastened without lines to at least two contacts (20, 21, 22, 23).

2. The resistance welding device (1) according to claim 1, **characterized in that** the two first contacts (20, 21) of the one polarity and the two additional contacts (22, 23) of opposite polarity are each arranged opposite each other, wherein the two additional contacts (22, 23) are substantially arranged offset to each other by 90° compared to the two first contacts (20, 21).

3. The resistance welding device (1) according to claims 1 or 2, **characterized in that** the synchronous rectifier (16) and the actuation circuit (17) are integrated in the heavy-current transformer (12).

4. The resistance welding device (1) according to any of claims 1 to 3, **characterized in that** the synchronous rectifier (16) comprises a plurality of switching elements (24) connected in parallel and that the switching elements (24) of the synchronous rectifier (16) are connected without lines with the at least one secondary winding (14) of the heavy-current transformer (12).

5. The resistance welding device (1) according to any of claims 1 to 4, **characterized in that** the heavy-current transformer (12) comprises a plurality of, preferably at least 10, primary windings (13) connected in series, and a plurality of, preferably at least 10, secondary windings (14) with center tapping connected in parallel.

6. The resistance welding device (1) according to any of claims 1 to 5, **characterized in that** the heavy-current transformer (12) comprises an I-beam (25) of electrically conductive material, in the recesses (25a) of which at least one respective ring core (15) is arranged, wherein one respective connection of each secondary winding (14) is directly contacted with one inner surface of the I-beam (25), and that the outer surfaces (28) of the I-beam (25) form the two first contacts (20, 21) of the power source (10), and that the center tapping of the at least one secondary winding (14) of the heavy-current transformer (12) is connected with the I-beam (25) without lines.

7. The resistance welding device (1) according to claim 6, **characterized in that** the at least one primary winding (13) of the heavy-current transformer (12) is arranged to run through the at least one ring core (15).

8. The resistance welding device (1) according to claims 6 or 7, **characterized in that** respective contact plates (29) are located above the recesses (25a) of the I-beam (25), said contact plates (29) being of electrically conductive material and connected with the respectively other connections of each secondary winding (14) via the synchronous rectifier (16) and the actuation circuit (17), wherein the outer surfaces of the contact plates (29) form the two additional contacts (22, 23) of the power source (10).

9. The resistance welding device (1) according to any of claims 1 to 8, **characterized in that** one secondary winding (14) with center tapping is each formed by two metal sheets (44, 45) insulated from each other and being of electrically conductive material and having a substantially S-shaped mirror-inverted course around the cross-section of a ring core (15) and through the ring core (15), wherein the exterior surfaces (47) of the metal sheets (44, 45) form the contacts for the connection with the circuit elements (24) of the synchronous rectifier (16) or the electrodes (7).

10. The resistance welding device (1) according to claims 8 or 9, **characterized in that** the I-beam (25) and the contact plates (29) of the heavy-current transformer (12) form a cube or cuboid-shaped unit, wherein an electrical insulation is arranged between the I-beam (25) and the contact plates (29), that cover plates (31) are arranged at the front faces of the I-beam (25), and that the cover plates (31) are formed of electrically conductive material and are adapted to be screwed to the contact plates (29), so that the contact plates (29) are connected electrically.

11. The resistance welding device (1) according to any of claims 6 to 10, **characterized in that** the I-beam (25) and/or the contact plates (29) and/or the cover plates (31) and/or the metal sheets (44, 45) for forming the secondary winding (14) of the heavy-current transformer (12) are formed of copper or a copper alloy, preferably with a silver coating.

12. The resistance welding device (1) according to any of claims 6 to 11, **characterized in that** the I-beam (25) and/or the contact plates (29) are formed at least partially by the gun arms (5).

13. The resistance welding device (1) according to any of claims 1 to 12, **characterized in that** at the connections of a secondary winding (14) a current transducer (18) each is arranged for measuring the current through this secondary winding (14), said current transducers (18) being connected with the actuation circuit (17).

14. The resistance welding device (1) according to claim 13, **characterized in that** the current transducers (18) are arranged to be oriented substantially 90° to the direction of the welding current.

15. The resistance welding device (1) according to claims 13 or 14, **characterized in that** the actuation circuit (17) is designed to activate the switching elements (24) of the synchronous rectifier (16) at a preset point in time prior to achieving zero crossing of the current in the secondary winding (14).

16. The resistance welding device (1) according to any of claims 8 to 15, **characterized in that** channels (39) for feeding a cooling fluid are arranged in the I-beam (25) and the contact plates (29), wherein two inlets (32) for feeding the cooling fluid and one outlet (33) for discharging the cooling fluid are arranged at an outer surface (28) of the I-beam (25), wherein the cooling channels (39) are arranged to extend from each inlet (32) to the contact plates (29) and via the I-beam (25) to the outlet (33).

17. The resistance welding device (1) according to any of claims 8 to 16, **characterized in that** the actuation circuit (17) and the synchronous rectifier (16) are arranged on at least one printed circuit board (35) which is arranged on the inner surface of at least one contact plate (29), and that each printed circuit board (35) of the synchronous rectifier (16) and of the actuation circuit (17) comprises openings (37) above which the switching elements (24) are arranged, and that the inner surface of the contact plates (29), in the places of the openings (37) in the printed circuit board (35) of the synchronous rectifier (16), comprises protrusions (36), in particular pinnacle-shaped protrusions, so that the switching elements (24) can be contacted without lines via the protrusions (36) protruding into the openings (37) on the printed circuit board (35) on the inner surface of the contact plates (29).

## Revendications

1. Dispositif de soudure à résistance (1) avec une source de courant (10) pour la production d'un courant de soudure pour la soudure de pièces (2, 3) comprenant une pince de soudure (4) avec deux bras de pince (5) présentant chacun une électrode (7) pour l'application du courant de soudure aux pièces (2, 3), la source de courant (10) comprenant un transformateur haute intensité (12) avec au moins un enroulement primaire (13) et au moins un enroulement secondaire (14) avec une prise médiane, un redresseur synchrone (16) relié avec l'au moins un enroulement secondaire (14) du transformateur haute intensité (12) présentant des éléments de commutation (24), et un circuit (17) pour le pilotage des éléments de commutation (24) du redresseur synchrone (16), **caractérisé en ce que** la source de courant (10) est disposée sur la pince de soudure (4) et **en ce que** la source de courant (10) comprend, pour la formation d'un contact multipoints à la sortie du redresseur synchrone (16), au moins quatre contacts (20, 21, 22, 23), ce qui diminue le courant de soudure au moins de moitié et réduit de ce fait les pertes de transition, deux premiers contacts (20, 21) d'une polarité étant reliés à un bras de pince (5) et deux contacts supplémentaires (22, 23) d'une polarité opposée étant reliés à l'autre bras de pince (5) et le bras de pince (5) étant fixé à au moins deux contacts (20, 21, 22, 23) sans fil.

2. Dispositif de soudure à résistance (1) selon la revendication 1, **caractérisé en ce que** les deux premiers contacts (20, 21) d'une polarité et les deux contacts supplémentaires (22, 23) de la polarité opposée sont disposés en face les uns des autres, les deux contacts supplémentaires (22, 23) étant disposés avec un décalage sensible de 90° entre eux par rapport aux deux premiers contacts (20, 21).

3. Dispositif de soudure à résistance (1) selon la revendication 1 ou 2, **caractérisé en ce que** le redresseur synchrone (16) et le circuit de pilotage (17) sont intégrés dans le transformateur haute intensité (12).

4. Dispositif de soudure à résistance (1) selon l'une des revendications 1 à 3, **caractérisé en ce que** le redresseur synchrone (16) comprend plusieurs éléments de commutation (24) branchés en parallèle et les éléments de commutation (24) du redresseur synchrone (16) sont reliés sans fil avec l'au moins un enroulement secondaire (14) du transformateur haute intensité (12).

5. Dispositif de soudure à résistance (1) selon l'une des revendications 1 à 4, **caractérisé en ce que** le transformateur haute intensité (12) comprend plusieurs, de préférence au moins 10, enroulements primaires (13) branchés en série et plusieurs, de préférence au moins 10, enroulements secondaires (14) branchés en parallèle avec une prise médiane.

6. Dispositif de soudure à résistance (1) selon l'une des revendications 1 à 5, **caractérisé en ce que** le transformateur haute intensité (12) comprend un support en I (25) en matériau électro-conducteur, dans les évidements (25a) duquel se trouve au moins un noyau annulaire (15), un raccordement de chaque enroulement secondaire (14) étant mis directement en contact avec une surface interne du support en I et **en ce que** les surfaces externes (28) du support en I (25) forment les deux premiers contacts (20, 21) de la source de courant (10) et **en ce que** la prise médiane de l'au moins un enroulement secondaire (14) du transformateur haute intensité (12) est reliée sans fil au support en I (25).

7. Dispositif de soudure à résistance (1) selon la revendication 6, **caractérisé en ce que** l'au moins un enroulement primaire (13) du transformateur haute intensité (12) s'étend à travers l'au moins un noyau annulaire (15).

8. Dispositif de soudure à résistance (1) selon la revendication 6 ou 7, **caractérisé en ce que**, au-dessus des évidements (25a) du support en I (25), se trouve une plaque de contact (29) en matériau électro-conducteur qui est reliée aux deux autres raccords de chaque enroulement secondaire (29) par l'intermédiaire du redresseur synchrone (16) et du circuit de pilotage (17), les surfaces externes des plaques de contact (29) formant les deux contacts supplémentaires (22, 23) de la source de courant (10).

9. Dispositif de soudure à résistance (1) selon l'une des revendications 1 à 8, **caractérisé en ce qu'**un enroulement secondaire (14) avec prise médiane est formée de deux tôles (44, 45) isolées entre elles en matériau électro-conducteur avec une extension essentiellement en forme de S autour de la section d'un noyau annulaire (15) et du noyau annulaire (15), les surfaces externes (47) des tôles (44, 45) formant les contacts pour la liaison avec les éléments de commutation (24) du redresseur synchrone (16) ou les électrodes (7).

10. Dispositif de soudure à résistance (1) selon la revendication 8 ou 9, **caractérisé en ce que** le support en I (25) et les plaques de contact (29) du transformateur haute intensité (12) forment une unité cubique ou parallélépipédique, une isolation électrique se trouvant entre le support en I (25) et les plaques de contact (29), des plaques de recouvrement (31) se trouvant sur les faces frontales du support en I (25) et les plaques de recouvrement (31) étant constituées d'un matériau électro-conducteur et pouvant être vissées avec les plaques de contact (29), de façon à ce que les plaques de contact (29) soient reliées électriquement.

11. Dispositif de soudure à résistance (1) selon l'une des revendications 6 à 10, **caractérisé en ce que** le support en I (25) et/ou les plaques de contact (29) et/ou les plaques de recouvrement (31) et/ou les tôles (44, 45) sont constitués, pour la formation de l'enroulement secondaire (14) du transformateur haute intensité (12), de cuivre ou d'un alliage de cuivre, de préférence avec un revêtement d'argent.

12. Dispositif de soudure à résistance (1) selon l'une des revendications 6 à 11, **caractérisé en ce que** le support en I (25) et/ou les plaques de contact (29) sont formées au moins partiellement par les bras de pince (5).

13. Dispositif de soudure à résistance (1) selon l'une des revendications 1 à 12, **caractérisé en ce que**, sur les raccordements d'un enroulement secondaire (14), se trouve un convertisseur de courant (18) pour la mesure du courant s'écoulant dans cet enroulement secondaire (14), ce convertisseur de courant (18) étant relié au circuit de pilotage (17).

14. Dispositif de soudure à résistance (1) selon la revendication 13, **caractérisé en ce que** les convertisseurs de courant (18) sont orientés sensiblement à 90° par rapport à la direction du courant de soudure.

15. Dispositif de soudure à résistance (1) selon la revendication 13 ou 14, **caractérisé en ce que** le circuit de pilotage (17) est conçu pour activer les éléments de commutation (24) du redresseur synchrone (16) à un moment prédéterminé avant le passage à zéro du courant dans l'enroulement secondaire (14).

16. Dispositif de soudure à résistance (1) selon l'une des revendications 8 à 15, **caractérisé en ce que**, dans le support en I (25) et les plaques de contact (29) se trouvent des canaux (39) pour le guidage d'un fluide de refroidissement, deux entrées (32) étant prévues sur une surface externe (28) du support en I (25) pour l'alimentation du fluide de refroidissement et une sortie (33) étant prévue pour l'évacuation du fluide de refroidissement, les canaux de refroidissement (39) s'étendant de chaque entrée (32) vers les plaques de contact (29) et par l'intermédiaire du support en I (25) vers la sortie (33).

17. Dispositif de soudure à résistance (1) selon l'une des revendications 8 à 16, **caractérisé en ce que** le circuit de pilotage (17) et le redresseur synchrone (16) sont disposés sur au moins une platine (35), cette platine (35) se trouvant sur la surface interne d'au moins une plaque de contact (29) et chaque platine (35) du redresseur synchrone (16) et du circuit de pilotage (17) comprenant des ouvertures (37) au-dessus desquelles les éléments de commutation (24) sont disposés et **en ce que** les surfaces internes des plaques de contact (29) présentent, aux endroits des ouvertures (27) dans la platine (35) du redresseur synchrone (16), des protubérances (36), plus particulièrement des protubérances de forme crénelée, de façon à ce que les éléments de commutation (24) peuvent être mis en contact sans fil, par l'intermédiaire des protubérances (36) dépassant à travers les ouvertures (37) de la platine (35) sur la surface interne des plaques de contact (35).
